(19) Europäisches Patentamt
European Patent Office
Office européen des brevets

(11) **EP 3 934 421 B1**

(12) **EUROPÄISCHE PATENTSCHRIFT**

(45) Veröffentlichungstag und Bekanntmachung des Hinweises auf die Patenterteilung:
**10.07.2024   Patentblatt 2024/28**

(21) Anmeldenummer: **20705279.6**

(22) Anmeldetag: **29.01.2020**

(51) Internationale Patentklassifikation (IPC):
**A01M 21/04** *(2006.01)*

(52) Gemeinsame Patentklassifikation (CPC):
**A01M 21/046**

(86) Internationale Anmeldenummer:
**PCT/EP2020/000027**

(87) Internationale Veröffentlichungsnummer:
**WO 2020/177919 (10.09.2020 Gazette 2020/37)**

(54) **VORRICHTUNG ZUR BEHANDLUNG EINES BODENS UND VERFAHREN ZUM BETREIBEN EINER DERARTIGEN VORRICHTUNG**

DEVICE FOR TREATING SOIL AND METHOD FOR OPERATING SUCH A DEVICE

DISPOSITIF DE TRAITEMENT D'UN SOL ET PROCÉDÉ DE FONCTIONNEMENT D'UN DISPOSITIF DE CE GENRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.03.2019   DE 102019001533**
**23.09.2019   DE 102019006646**

(43) Veröffentlichungstag der Anmeldung:
**12.01.2022   Patentblatt 2022/02**

(73) Patentinhaber: **Zasso Group AG**
**6300 Zug (CH)**

(72) Erfinder:
- **FREIMANN, Christopher**
  **52249 Eschweiler (DE)**
- **DE ANDRADE COUTINHO FILHO, Sergio**
  **13337-412 Indaiatuba (BR)**

(74) Vertreter: **Weidner Stern Jeschke**
**Patentanwälte Partnerschaft mbB**
**Universitätsallee 17**
**28359 Bremen (DE)**

(56) Entgegenhaltungen:
| | |
|---|---|
| EP-A1- 0 026 248 | EP-A1- 0 026 248 |
| EP-A2- 1 256 275 | EP-A2- 1 256 275 |
| WO-A1-2012/059335 | WO-A1-2012/059335 |
| WO-A1-2018/050138 | WO-A1-2018/050138 |
| WO-A1-2018/095451 | WO-A1-2018/095451 |
| CN-B- 104 714 152 | CN-B- 104 714 152 |
| JP-A- H05 103 573 | JP-A- H05 103 573 |
| US-A- 4 338 743 | US-A- 4 338 743 |
| US-A1- 2018 325 091 | US-A1- 2018 325 091 |

**Beschreibung**

Die Erfindung betrifft eine Sicherheitsvorrichtung mit einer Hochspannungseinrichtung zum Erzeugen einer Hochspannung und Hochspannungselektroden zum Einleiten der Hochspannung in einen ersten Bodenbereich zur Unkrautinaktivierung, die aus einer spezifischen Kombination von Teilen besteht, die durch verschiedene Verbindungsarchitekturen in verschiedenen Ausführungsformen von Unkrautinaktivierungsvorrichtungen zusammengesetzt werden können, um die Betriebssicherheit zu gewährleisten. Der Betrieb von Hochspannungseinrichtungen führt zu verschiedenen Risiken für den Betreiber der Vorrichtung. Daher werden verschiedene Vorrichtungen vorgeschlagen, die dieses Risiko senken oder sogar eliminieren.

Aus JP H05 103573 A ist ein Unkrautentfernungsgerät bekannt, welches einen Hochspannungserzeugungsstab und eine Hochspannungserzeugungsvorrichtung umfasst, wobei letztere auf einen Wagen montiert ist und mittels eines Kabels mit dem Hochspannungserzeugungsstab verbunden ist. Der Hochspannungserzeugungsstab weist eine längliche Rohrform aus einem isolierenden Material und innenliegend eine Hochspannungselektrode auf. Eine Spitze des Hochspannungserzeugungsstabes wird vom Benutzer auf ein zu behandelndes Unkraut gerichtet und eine Hochspannung mittels Funkenentladung über die Luft übertragen, sofern ein Erdungselement und ein Erfassungselement in demselben Boden angeordnet sind und ein normaler Widerstandswert zwischen beiden detektiert wird.

WO 2018/095451 A1 offenbart ein Verfahre zur Pflege von Bodenflächen mit einer Unkrautvernichtungsvorrichtung, bei dem zu verschiedenen Zeitpunkten Daten zum Unkrautbewuchs ermittelt und mit einem Rechner daraus eine Prognose zum Unkrautbewuchs errechnet wird. Zur Unkrautvernichtung können an einer Vorderseite eines Fahrzeuges drei feste Schleifapplikatoren, beispielsweise ausgebildet als Bürsten und bewegliche Schleif- oder Bürstenapplikatoren als Applikatoren einer Hochspannungserzeugungseinrichtung hinten am Fahrzeug angeordnet sein. Zusätzlich kann hinten am Fahrzeug ein entfernbares Kleinsystem verbunden sein, welches Schleifkontakte aufweist und auf einem Luftpolster schwebt oder auf Rädern schleift oder rollt.

Die Aufgabe wird gelöst durch eine Vorrichtung zur Behandlung eines Bodens, mit folgenden Elementen: einem Trägerfahrzeug, das ein Chassis aufweist, einem Gehäuse mit elektrischen Komponenten, einer Sicherheitsvorrichtung mit einer Hochspannungseinrichtung zum Erzeugen einer Hochspannung, und Hochspannungselektroden, wobei die Sicherheitsvorrichtung aus einer Hochspannungsisolationsüberwachung und/oder einer mehrstufigen elektrischen Isolierung und/oder einem Näherungssensor und/oder einer Näherungsverriegelung und/oder einer Sollpositionserfassung besteht, und die Hochspannungselektroden derart eingerichtet sind, dass die Hochspannung in einem ersten Bodenbereich zur Unkrautinaktivierung mittels eines Nutzstroms zwischen den Hochspannungselektroden einleitbar ist, und die Sicherheitsvorrichtung eine Messeinrichtung mit einer Auswerteelektronik aufweist, um einen Fehlerstrom oder eine Fehlerspannung zwischen einzelnen Elementen der Vorrichtung untereinander oder zwischen einzelnen Elementen und einer Erdung zu messen, wobei die Erdung zum Ableiten des Fehlerstroms in einem zweiten Bodenbereich dient und ein Abstand zwischen den Hochspannungselektroden und der Erdung mindestens 2 m beträgt.

Eine dieser Vorrichtungen ist eine Vorrichtung mit einem Chassis zur Behandlung eines Bodens, mit folgenden Elementen: einem Trägerfahrzeug, das ein Chassis aufweist, einem Gehäuse mit elektrischen Komponenten wie insbesondere einer Hochspannungseinrichtung zum Erzeugen einer Hochspannung, und Hochspannungselektroden, zum Einleiten der Hochspannung in einen ersten Bodenbereich. Außerdem betrifft die Erfindung ein Verfahren zum Betreiben einer derartigen Vorrichtung.

Die Anmeldung beschäftigt sich insbesondere mit dem Detektieren von Ableit- und Kurzschlussströmen auf mobilen oder nicht mobilen Anwendungen wie an Traktoren oder manuell geführten Einrichtungen mit interner Leistungsbereitstellung und erdkontaktierenden Hochspannungselektroden. Derartige Vorrichtungen werden für das Unkrautmanagement verwendet. Dabei wird in einem Ausführungsbeispiel auf einem Trägerfahrzeug, wie beispielsweise einem Traktor, mittels Motoranzapfung ein Generator angetrieben, welcher elektrische Energie zur Verfügung stellt. Die Energie kann aber auch von einer kleinen manuell führbaren Einrichtung bereitgestellt werden. Mittels Transformatoren wird Hochspannung erzeugt, welche nach Gleichrichtung mithilfe von Elektroden einen Stromfluss durch die Pflanzen zur Folge hat. Dieser Stromfluss wird auch als Nutzstromfluss bezeichnet und wirkt wachstumsbeeinträchtigend oder zerstörend auf Pflanzen, wie insbesondere Unkräuter als auch auf Mikroorganismen und Tiere, wie insbesondere Schädlinge.

Zur Bereitstellung der benötigten elektrischen Energie gibt es prinzipiell mehrere Möglichkeiten. Zum einen kann ein Batteriesystem mit Batteriemanagement auf dem Trägerfahrzeug installiert werden. Alternativ kann mittels eines Motors, welcher standardmäßig auf Traktoren verbaut ist, ein Generator angetrieben werden. Beide Möglichkeiten können als TN-Netz- oder IT-Netz aufgebaut werden.

Die Vorrichtung mit Chassis kann ein Trägerfahrzeug, wie beispielsweise ein Traktor sein. Es kann jedoch auch eine handgeführte mobile Einrichtung sein, ein Autonomer oder eine andere über einen Boden geführte Einrichtung, die der Behandlung des Bodens dient.

Elektroautos werden aus Konstruktions- und Sicherheitsgründen stets als IT-Netz entwickelt. Dabei wird mittels Isolationsüberwachung (IMD) sichergestellt, dass das Netz stets vom Chassis isoliert ist. Weitere Anwendungen für IT-Netze sind versorgungskritische Einrichtungen, wie Krankenhäuser, da hier ein einpoliger Erdschluss nicht zum Ausfall des Netzes führt. Bei TN-Netzen, wie sie üblicherweise im Versorgungsnetz angewendet werden, kann über Differenzstromüberwachung (RCD) ein Fehlerstrom detektiert werden. Dabei kommen üblicherweise RCD Typ A zum Einsatz, welche eine 30 mA-Fehlerstrom-Schutzeinrichtung darstellen. Bei Anwendungen, bei denen auch ein DC-Anteil im Fehlerstrom zu erwarten ist, wie beispielswiese beim Ladevorgang eines Elektroautos, kann ein RCD oder ein RCM (residual current monitoring) Typ B (allstromsensitiv) eingesetzt werden oder es wird eine RCMU (Residual Current Monitoring Unit) vorgeschaltet.

Aufgrund von kapazitiver Kopplung, zum Beispiel im Bereich des Hochspannungstransformators oder aufgrund von einpoligen Kurzschlüssen können Zustände erreicht werden, bei denen das Chassis der Vorrichtung auf unzulässige Spannungsniveaus angehoben wird.

Da Fahrzeuge in der Regel nicht geerdet sind und die Reifen als Isolierung wirken, kann eine derartige Vorrichtung als vom Boden isoliert betrachtet werden. Besonders kritisch sind dabei einpolige Kurzschlüsse zwischen der Hochspannung und dem Rest des Systems. Diese können beispielsweise durch Versagen der Isolation im Bereich des Transformators, der Hochspannungskabel, der Applikatoren oder jeglicher Anschlüsse und Steckverbinder im Hochspannungskreis auftreten. Grund dafür können eine Falschauslegung des Isolationskonzeptes oder Alterungsmechanismen des Isolationsmaterials sein. Bekannte Phänomene in Feststoffisolationen wie Teilentladungsaktivität oder electrical treeing aufgrund von Materialunreinheiten (Lufteinschlüsse, Feststoffeinschlüsse) können sowohl kurz-, mittelals auch langfristig zur Materialermüdung führen und eine Erhöhung der Leckströme hervorrufen oder Durchschlagsmechanismen starten.

Bei Verwendung von flüssigen Isolierstoffen (zum Beispiel bei ölisolierten Transformatoren) können neben einer Überbeanspruchung auch Faserbrückendurchschläge oder eine erhöhte Feuchtigkeit oder Verschmutzung zum Versagen der Isolationseigenschaft führen.

Bei den erfindungsgemäßen Vorrichtungen zur Behandlung eines Bodens besteht zusätzlich das Risiko, das der Bodenbewuchs sowohl eine Elektrode als auch das Chassis der Vorrichtungen berührt und somit direkt ein einpoliger Kurzschluss verursacht wird. Auf welches Spannungsniveau das Chassis in diesem Fall erhöht wird, hängt vor allem von der Spannung an den Hochspannungselektroden, der Leitfähigkeit der Pflanze und den Übergangswiderständen von den Hochspannungselektroden zur Pflanze und von der Pflanze zum Chassis der Vorrichtung (Trägerfahrzeug) ab.

Es geht daher generell um ein Sicherheitssystem zur Gefahrenabwehr für elektrische Unkrautbekämpfungsvorrichtungen, wobei an erster Stelle ein Kurzschluss zwischen Elektroden und dem Rest des Systems steht.

Zur Lösung dieser Probleme wird vorgeschlagen, dass eine gattungsgemäße Sicherheitsvorrichtung aus einer Hochspannungsisolationsüberwachung und/oder einer mehrstufigen elektrischen Isolierung und/oder einem Näherungssensor und/oder einer Näherungsverriegelung und/oder einer Sollpositionserfassung besteht, die die Position der Elemente zueinander erfasst. Eine derartige Vorrichtung weist eine Messeinrichtung mit einer Auswerteelektronik auf, um einen Fehlerstrom oder eine Fehlerspannung zwischen einzelnen Elementen der Vorrichtung untereinander oder zwischen einzelnen Elementen und einer Erdung zu messen, die zum Ableiten eines Fehlerstroms in einem zweiten Bodenbereich dient.

Der Erfindung liegt somit die Erkenntnis zugrunde, dass es verschiede Möglichkeiten gibt das Risiko von unerwünschten Spannungen zu reduzieren. Beispielsweise kann zur Generierung eines detektierbaren Fehlerstroms bei einem Isolationsfehler eine Erdung des Fahrzeugs oder einer anderen Einrichtung in Kombination mit einer Isolationsüberwachung vorgesehen werden. Die Isolationsüberwachung kann dabei eine niederohmige, allstromsensitive Erdstrommessung mit entsprechender Auswerteelektronik sein. Die Auswerteelektronik kann eine Fehlerstromüberwachungseinheit (RCMU) sein. Dazu kann eine Fehlerstrom-Schutzeinrichtung (RCD), wie beispielsweise ein RCD Typ B eingesetzt werden, durch den nur der Erdleiter erfasst wird.

Das Gehäuse mit den elektrischen Komponenten kann eine Plattformversorgung aufweisen und zwischen dem Applikator und dem Trägerfahrzeug kann eine Aufnahme für Anbaugeräte angeordnet sein. Vorzugsweise ist ein Adapter zwischen Applikator und Aufnahme vorgesehen.

Die Größe des Fehlerstroms ist abhängig von der an den Elektroden anliegenden Spannung, der Art des Kurzschlusses, der Impedanzverteilung im Boden und den Übergangsimpedanzen der Applikatoren zur Pflanze, beziehungsweise zur Erde, und von dem Boden zur Erdung der Vorrichtung, wie insbesondere des Fahrzeugs.

Der Fehlerstrom $I_{Fehler}$ lässt sich in Abhängigkeit des Gesamtstromes $I_{Gesamt}$ bestimmen:

$$\underline{I}_{Fehler} = \underline{I}_{Gesamt} * \frac{\underline{Z}_1}{\underline{Z}_1 + \underline{Z}_2}$$

Der Fehlerstrom lässt sich auch in Abhängigkeit des Nutzstromes $I_{Nutz}$ bestimmen:

$$\underline{I}_{Fehler} = \underline{I}_{Nutz} * \frac{\underline{Z}_1}{\underline{Z}_2}$$

Da der Fehlerstrom von dem Gesamtstrom abhängt, kann zur Generierung eines Fehlerstromes in einem fehlerhaften System ein minimaler Gesamtstrom definiert werden. Dieser muss während des Betriebs der Vorrichtung erreicht werden, damit die Fehlerdetektion im Fehlerfall aktiv werden kann.

Die der Erfindung zugrundeliegende Aufgabe wird daher auch mit einem Verfahren zum Betreiben einer derartigen Vorrichtung gelöst, bei dem das Einleiten der Hochspannung unterbrochen wird, wenn der Fehlerstrom oder die Fehlerspannung einen Grenzwert überschreitet oder die Näherungssperre, Zielpositionserkennung oder der Näherungssensor eine Störung detektiert haben.

Kumulativ oder alternativ kann die Messeinrichtung auch den Ort der Vorrichtung anzeigen, an dem der Grenzwert überschritten wurde. Dadurch ergibt sich beispielsweise eine Drahtbrucherkennung.

Vorteilhafte Weiterbildungen sind Gegenstand der Unteransprüche.

In der Praxis wird somit eine Abschaltbedingung definiert, bei der der Gesamtstrom (oder die abgegebene Leistung) über die Zeit gemittelt wird. Bei Überschreitung des Grenzwertes wird die Vorrichtung abgeschaltet und der Bediener muss aktiv handeln, um das System wieder in Betrieb zu nehmen. Sofern konstruktiv sichergestellt werden kann, dass bei Berührung kein tödlicher oder verletzender Körperstrom fließt, kann auf die Abschaltbedingung verzichtet werden.

Bei der Positionierung der Erdung ist zu beachten, dass es aufgrund der erdkontaktierenden Hochspannungselektroden zur Anhebung des lokalen Erdpotentials kommen kann. Durch Bildung eines Spannungstrichters muss sichergestellt werden, dass der Kontakt zur Erde dort stattfindet, wo das Erdpotential kleiner ist als die definierten Grenzwerte der Berührspannung. Ist dies nicht der Fall, kann das Chassis der Vorrichtung unzulässige Spannungsniveaus erreichen. Dies berücksichtigend wird erfindungsgemäß vorgeschlagen, dass der Abstand zwischen den Hochspannungselektroden und der Erdung mindestens 2 m vorzugsweise mehr als 3 m betragen sollte.

Die Erdung verbindet als Erdungselement das Chassis eines Trägerfahrzeugs der Vorrichtung oder ein Anbauteil mit dem Boden (Erdpotential). Ein gutes Erdungselement hat einen geringen Widerstand und einen möglichst geringen Erdübergangswiderstand und beschränkt die Manövrierfähigkeit des Fahrzeuges möglichst wenig.

Vorteilhaft ist es daher, wenn die Erdung eine Kette oder eine Kette mit daran befestigtem Kabel aufweist. Das Kabel ist dabei vorzugsweise durch Glieder der Kette gefädelt. Ein Gewicht an der Kette kann dafür sorgen, dass ein Ende der Kette immer auf dem Boden aufliegt. Eine Kette in Kombination mit einem Kabel bietet eine hohe Flexibilität. Daher wird die Manövrierfähigkeit eines Fahrzeuges nicht beeinflusst. Um den Übergangswiderstand der einzelnen Kettenglieder zueinander zu verringern, kann ein Kabel, wie beispielsweise eine Kupferflachlitze, durch die einzelnen Kettenglieder gefädelt und verschraubt werden. Mit Hilfe von zusätzlichen Gewichten oder Schneidelementen kann der Erdübergangswiderstand verringert werden.

Kumulativ oder alternativ kann die Erdung daher mindestens ein Schneidelement aufweisen. Dieses Schneidelement kann ein Schneidmesser oder ein Schneidteller sein. Derartige Schneidelemente können in den Boden gedrückt werden. Schneidelemente haben gegenüber der Kette den Vorteil des geringeren Erdübergangswiderstandes.

Als weitere Verbesserung wird vorgeschlagen, dass die Erdung leitfähige Matten aufweist. Matten haben den Vorteil, sehr großflächig eingesetzt werden zu können. Je schwerer eine Matte ist, desto geringer ist der Erdübergangswiderstand. Dieser kann somit durch Zusatzgewichte verringert werden.

Die Erdung kann auch mindestens ein Rad aufweisen, das elektrisch leitend mit dem Chassis des Trägerfahrzeugs oder eines Anbauteils verbunden ist. Dieses Rad kann ein Stützrad zum Abstützen des Chassis oder eines Anbauteils oder eines Rahmens sein und eine Bürste oder einen Schleifkontakt aufweisen. Das Rad kann dabei als Stützrad einzelne Elemente abstützen und erden. Außerdem kann das Stützrad höhenverstellbar sein, um die Position der Elektroden einzustellen.

Zur Entlastung des Antriebsfahrzeuges und insbesondere bei Verwendung von autonomen Fahrzeugen oder Schienenfahrzeugen können auch die Räder als Erdungselement oder als Rückleiter verwendet werden. Ebenso können die Räder von nicht autonomen Fahrzeugen, bemannten Fahrzeugen oder Fahrzeugen mit Antrieb als Erdungselement oder Rückleiter verwendet werden. Bei Verwendung als Erdungselement ist ein ausreichend hoher Abstand zu dem Applikationsraum vorzusehen. Die Fläche, mit welcher das Rad den Boden berührt, ist dabei aus leitfähigem Material (z.B. Metall oder Stahl). Diese Fläche hat eine elektrische Verbindung zum Fahrgestell (ggf. mit Schleifringkontakten).

Stützräder können aber auch aus nicht hochleitfähigem Material, wie z.B. einer Kautschukmischung, verwendet werden, wenn diese nicht als Erdungselement oder Rückleiter dienen. Auf die Hochspannungsisolation zum Rahmen kann dennoch nicht verzichtet werden.

Zur Erhöhung der Detektionswahrscheinlichkeit können die Erdungspunkte der Erdung redundant und räumlich möglichst verteilt ausgelegt werden. Daher wird vorgeschlagen, dass die Erdung mehrere um mindestens 5 cm beabstandete Erdungspunkte zum Ableiten in unterschiedliche Bodenbereiche aufweist. Diese Erdungspunkte können jeweils einer Sensorik zugeführt werden oder parallel geschaltet werden. Ein Versatz längs und quer zur Fahrtrichtung kann bei einer längs oder quer zur Vorrichtung angeordneten Bodenauflagefläche den vollständigen Verlust des Erdpotentials verhindern.

Weitere vorteilhafte Schaltungen ergeben sich, wenn parallel zum Ableiten des Fehlerstroms ein Filter angeordnet ist.

Die Hochspannungseinrichtung kann mehrere Module aufweist, deren Leistung geregelt und begrenzt ist, und sie kann mehrere parallel geschaltete Umrichter aufweisen.

Um einen Kurzschluss aufgrund von Pflanzen, die sowohl eine Hochspannungselektrode als auch das Chassis berühren, zu vermeiden, wird vorgeschlagen, dass die Hochspannungselektroden in einem gegenüber dem Chassis, einem Anbauteil oder Anbauteile isolierten Applikatorraum angeordnet sind. Ein derartiger Applikatorraum kann eine Feststoffisolierung und Luftstrecken zur Isolation der Hochspannungselektroden aufweisen.

Da hoher Bodenbewuchs Anbauteile oder das Chassis der Vorrichtung, wie insbesondere eines Trägerfahrzeugs, berühren kann, wird hierdurch die Wahrscheinlichkeit, dass ein Isolationsfehler kurzzeitig detektiert wird, verringert. Die Berührung führt zu einem parallel zur installierten Erdung fließenden Fehlerstromkreis, der nicht detektierbar ist, oder zur Anhebung des Potentials vom Trägerfahrzeug und/oder Anbauteilen.

Daher wird vorgeschlagen, zwischen den Elementen, wie insbesondere dem Chassis oder Anbauteilen und/oder der Hochspannungseinrichtung, einerseits und dem Boden andererseits eine Isolation anzuordnen. Zum Boden hin nicht isoliert bleiben die Hochspannungselektroden und die Erdung. In der Praxis werden zum Verringern dieses Anteils an nicht detektierbaren Fehlerströmen die Unterseite des Chassis und aller weiterer Anbauteile so isoliert, dass es zu keinem Kontakt der Pflanzen mit dem Chassis kommt.

Vorteilhaft ist es, wenn einzelne und vorzugsweise alle Elemente einzeln elektrisch isoliert sind. Dies erlaubt es, auch einen Fehlerstrom oder eine Fehlerspannung zwischen diesen gegeneinander isolierten Elementen durchzuführen.

Gerade die Hochspannungselektroden und Applikatoren können separat von anderen Elementen, wie auch von anderen Hochspannungselektroden und Applikatoren oder vom Rest der Vorrichtung isoliert sein.

Besonders vorteilhaft ist es, wenn einzelne Elemente wie insbesondere die Applikatoren aus elektrisch isolierendem Material hergestellt sind. Auch das Chassis, Adapter und Aufnahmen für Anbaugeräte oder Applikatoren können nicht nur gegenüber anderen Elementen isoliert sein, sondern auch aus elektrisch isolierendem Material hergestellt sein.

Besonders vorteilhaft ist es, wenn die Vorrichtung ein Trägerfahrzeug aufweist und zum Einleiten der Hochspannung in den Boden Hochspannungselektroden vor und seitlich des Trägerfahrzeugs angeordnet sind. Eine derartige Flügelanordnung, die im Agrarbereich bei verschiedenen Anwendungen eingesetzt wird, ermöglicht es zusätzlich zu dem üblicherweise eingesetzten Elektrodenpaar vor dem Trägerfahrzeug zwei weitere Elektrodenpaare seitlich des Fahrzeuges zu installieren, um die Arbeitsbreite zu vergrößern.

Ein vollständiger Verlust der Erdungselemente (z.B. durch Abreißen oder Demontage) oder eine fehlerhafte Inbetriebnahme (Fixierung der Erdungselemente für den Transport) kann dazu führen, dass das Chassis und/oder Anbauteile nicht geerdet sind. Aus diesem Grund muss sichergestellt werden, dass sich die Erdungselemente im Betrieb an den dafür vorgesehenen Stellen befinden.

Daher ist es vorteilhaft, wenn die Vorrichtung eine erste Schleifenüberwachung aufweist, um die Funktion der Erdung zu überwachen. Eine Schleifenüberwachung kann sicherstellen, dass ein mechanischer Verlust oder eine Beschädigung des Erdungselements detektiert wird. Dabei wird in einen fest verdrahteten, niederohmigen Stromkreis ein Ruhestrom (Typ.: einige mA) eingekoppelt und gemessen. Wird der Stromkreis an einer Stelle unterbrochen oder wird er geschlossen, kann dies detektiert werden. Entsprechende Elektronik (Schleifenüberwachungsrelais) ist als Standardbauteil zu kaufen und kann in das hier vorgestellte Konzept integriert werden. Bei Fehlerdetektion kann über eine Safety-SPS das gesamte System in einen sicheren Zustand gebracht werden.

Wird das Gesamtsystem transportiert, besteht die Möglichkeit die Handhabung durch Verwendung von Befestigungspunkten zu vereinfachen. Diese Befestigungspunkte dienen dazu, die Erdungselemente für den Transport zu fixieren. Wird das Gesamtsystem für den Betrieb vorbereitet, muss der Inbetriebnehmer die Befestigungselemente manuell lösen oder das Lösen wird vom System automatisiert durchgeführt. Dabei kann das Lösen der Befestigungen nicht oder nicht vollständig, bzw. fehlerhaft durchgeführt werden.

Vorteilhaft ist es, wenn sie mindestens einen Befestigungspunkt zum Fixieren eines Erdungselementes während des Transports aufweist und dieser Befestigungspunkt eine zweite Schleifenüberwachung aufweist.

Kumulativ oder alternativ zur zweiten Schleifenüberwachung kann die Vorrichtung mindestens einen Befestigungspunkt zum Fixieren eines Erdungselementes der Erdung während des Transports aufweisen, wobei dieser Befestigungspunkt einen mechanischen Schalter aufweist. Ein mechanischer Schalte kann beispielsweise ein Seilzugschalter oder ein Hebelschalter sein. In manchen Ausführungsvarianten ist es vorteilhaft, wenn zwischen der Erdung und dem Schalter eine Feder angeordnet ist.

Insbesondere für Anwendungen auf dem Gebiet der Eisenbahn- und Schienentechnik wird vorgeschlagen, dass die Vorrichtung mindestens ein Rad aufweist, das elektrisch leitend für ein Abrollen auf einer Schiene ausgebildet ist. Dies ermöglicht es, die elektrischen Komponenten wie Generator und Umrichter vom Zugfahrzeug (Zug, Unimog) zu isolieren. Über eine definierte Verbindung, wie insbesondere ein Kabel, welches die elektrischen Komponenten mit dem Zug verbindet, kann ein Versagen der Hochspannungsisolierung mittels Feherstrommessung detektiert werden.

Besonders vorteilhaft und auch unabhängig von den zuvor beschriebenen Merkmalen erfindungswesentlich ist eine Vorrichtung, die eine Näherungssperre, einen Näherungssensor oder eine Zielpositionserkennung für einzelne Elemente der Vorrichtung wie insbesondere der Elektroden und der Erdung aufweist.

Dabei kann die Näherungssperre eine mindestens ein Element umgebende Zugangsbarriere sein.

Die Näherungssperre kann auch mindestens einen Seilzug, Hebelschalter, ein und ausklapp- oder fahrbares Gestänge oder Mikroschalter aufweisen.

Wenn die Vorrichtung einen Näherungssensor aufweist, dann kann dieser eine Kamera zur Bilderkennung und Bildauswertung, Ultraschall- oder Radarsensoren aufweisen.

Vorteilhaft ist es, wenn die Vorrichtung eine Messeinrichtung, mit der die Position der Elemente zueinander und/oder zum Untergrund messbar ist, eine Positions-, Beschleunigungs- oder Neigungsüberwachung für den Oberlenker oder für ein Fahrwerk aufweist.

Die Messeinrichtung, mit der die Position der Elemente zueinander und/oder zum Untergrund messbar ist, kann Elektrodendrucksensoren, Ultraschall- oder Radarsensoren aufweisen.

Wenn die Vorrichtung höhenverstellbare Räder und/oder ein höhenverstellbares Fahrwerk aufweist, ist es möglich die Höhenposition der Elektroden einzustellen.

Um an einem herkömmlichen Fahrzeug unterschiedliche Elemente befestigen zu können, ist es vorteilhaft, wenn die Vorrichtung einen Adapter aufweist, der zwischen der Aufnahme für Anbaugeräte und dem Applikator angeordnet ist.

Vorteilhaft ist es, wenn die Hochspannungseinrichtung mehrere Module aufweist, deren Leistung geregelt und begrenzt ist. Eine Aufteilung der Gesamtenergie durch die Verwendung von Modulen reduziert die Energie im Fehlerfall, welche im menschlichen Körper umgesetzt wird. Wird der Stromkreis zwischen einem Pluspol und einem Minuspol durch den menschlichen Körper gebrückt oder nur teilweise gebrückt, steht diesem Stromkreis durch Aufteilung der Gesamtenergie nur die Energie eines Moduls zur Verfügung. Grundlage dafür ist, dass die Leistung eines Moduls geregelt oder begrenzt wird. Die Module können dabei eingangsseitig ein- oder mehrpolig ausgeführt werden. Dies reduziert die Wahrscheinlichkeit eines tödlichen Fehlerstroms.

Besonders vorteilhaft und auch unabhängig von den zuvor beschriebenen Merkmalen erfindungswesentlich ist daher eine Vorrichtung, die mehrere Hochspannungsmodule mit Hochspannungsausgängen aufweist, bei denen mindestens ein Pol der Hochspannungsausgänge mit den Hochspannungsausgängen der anderen Module mit gleicher Polarität überbrückt wird, um eine Reihenschaltung der Hochspannungsmodule zu verhindern.

Ein System kann aus mehreren parallelgeschalteten Umrichtern bestehen. Liegt ein Isolationsfehler zum Gehäuse eines Umrichters vor, kann eine Fehlerortung durchgeführt werden. Dazu kann ein Aufbau gewählt werden, bei dem die Gehäuse der Umrichter vom Chassis isoliert installiert werden. Durch die Verwendung von RCM-Technik kann der fehlerhafte Umrichter identifiziert werden. Zu unterscheiden ist dabei ein Fehler auf der Niederspannungsseite von einem Fehler auf der Hochspannungsseite.

Ein weiterer Vorteil besteht in der höheren Ergebnisqualität bzgl. der biologischen Leistung der Applikation.

Dabei ist es vorteilhaft, wenn an der Überbrückung eine Strommesseinrichtung angeordnet ist.

Außerdem ist es von Vorteil, wenn die Auswerteelektronik ein Sicherheitsrelais aufweist, das in Reihe mit Not-Ausschaltern und weiteren Teilsicherheitseinheiten geschaltet ist.

Wird im Spezialfall eines TN-C-Systems ein PEN-Leiter verwendet, ist darauf zu achten, dass dieser nur im Falle symmetrischer Belastung zur Isolationsüberwachung im Hochspannungskreis dient.

Ein zweipoliger Kurzschluss auf der Hochspannungsseite ist nicht kritisch, da in diesem Fall aufgrund des Überstroms abgeschaltet wird oder bei geregelten Systemen die Spannung heruntergeregelt wird.

Eine vorteilhafte Weiterbildung des Verfahrens sieht vor, dass mit der Messeinrichtung die Erdungsimpedanz oder die Lastimpedanz durch Spannungs- und/oder Strommessung bestimmt wird.

Außerdem kann die Geschwindigkeit der Vorrichtung relativ zum Boden gemessen werden und davon abhängig kann die abgegebene Energiemenge festgelegt werden.

Eine besonders vorteilhafte Verfahrensvariante sieht vor, dass der Unkrautbewuchs ermittelt wird und davon abhängig die abgegebene Energiemenge und/oder die Position der Elektroden festgelegt wird.

Darüber hinaus kann die Auswerteelektronik ein Sicherheitsrelais aufweisen, das in Reihe mit Not-Ausschaltern und weiteren Teilsicherheitseinheiten geschaltet ist.

Mehrere Ausführungsbeispiele erfindungsgemäßer Vorrichtungen sind in der Zeichnung dargestellt und werden im Folgenden näher beschrieben. Es zeigt

| Figur 1 | einen Traktor mit erdkontaktierenden Hochspannungselektroden und Transformatoren, |
|---|---|
| Figur 2 | einen einpoligen Kurzschluss im TN-S-System (links) und im IT-System (rechts), |
| Figur 3 | die Stromaufteilung in Nutzstrom und zu detektierenden Fehlerstrom, |
| Figur 4 | das Funktionsprinzip der Fehlerstrommessung im TN-S-System (links) und im IT-System (rechts), |
| Figur 5 | die Potenzialverteilung auf der Bodenoberfläche bei angelegter Spannung bei einem |

Figur 6    einen Traktor mit in einem Applikatorraum angeordneten Hochspannungselektroden,

Figur 7    die Aufteilung eines Fehlerstroms in einen detektierbaren und einen nicht detektierbaren Anteil,

Figur 8    die elektrische Isolation der Fahrzeugunterseite und der Anbauteile,

Figur 9    die Potenzialverteilung auf der Bodenoberfläche bei angelegter Spannung und Flügelanordnung der Hochspannungselektroden,

Figur 10    eine Schaltung zur Erfassung der Fehlerströme,

Figur 11    eine Schaltung für die Verwendung von RCM-Technik zum Detektieren von niederspannungsseitigen Isolationsfehlern,

Figur 12    eine Anordnung zum Detektieren von hochspannungsseitigen Isolationsfehlern,

Figur 13    zwei Anordnungen zum Isolieren gegenüber dem Chassis,

Figur 14    schematisch den Aufbau einer Schleifenüberwachung,

Figur 15    eine Verschaltung bei Verwendung mehrerer Erdungselemente,

Figur 16    eine Montage- bzw. Demontageüberwachung,

Figur 17    die Fixierung von Erdungspunkten für den Transport,

Figur 18    Schleifenüberwachungen als Befestigungsüberwachung,

Figur 19    eine weitere Möglichkeit der Transportsicherung,

Figur 20    die Verwendung von Rädern als Erdungselement oder als Rückleiter,

Figur 21    die Verwendung von mehr als einem Stützrad,

Figur 22    eine elektrische Verbindung zwischen den Rädern,

Figur 23    die Isolation eines Applikationsraums,

Figur 24    die einzelnen Elemente des Systems am Beispiel eines Traktors,

Figur 25    schematisch die einzelnen Elemente des Systems,

Figur 26    eine Verteilung der Gesamtenergie über Module,

Figur 27    Erdungs- und Fehlerstrommessungen bei Bahnanwendungen,

Figur 28    eine Effizienzsteigerung durch den Einsatz der Schiene bei Bahnanwendungen,

Figur 29    eine Isolierung des Stromnetzes gegen das Fahrzeugchassis,

Figur 30    vier Konzepte, um die Elektroden vom Rest des Systems zu isolieren,

Figur 31    Gefahrenbereiche um den Anwendungsbereich

Figur 32    einen ausfahrbaren Seitenschutz,

Figur 33    einen Schutz mit Seil und Zugschalter,

Figur 34    eine Positionierung des Rahmens mit Neigungssensoren,

Figur 35    eine Einrichtung zum Erfassen des Elektrodenstatus,

Figur 36    eine Schaltung zur Bestimmung des biologischen Effektes der Vorrichtung und

Figur 37    eine Einrichtung zur Messung der Rahmenhöhe.

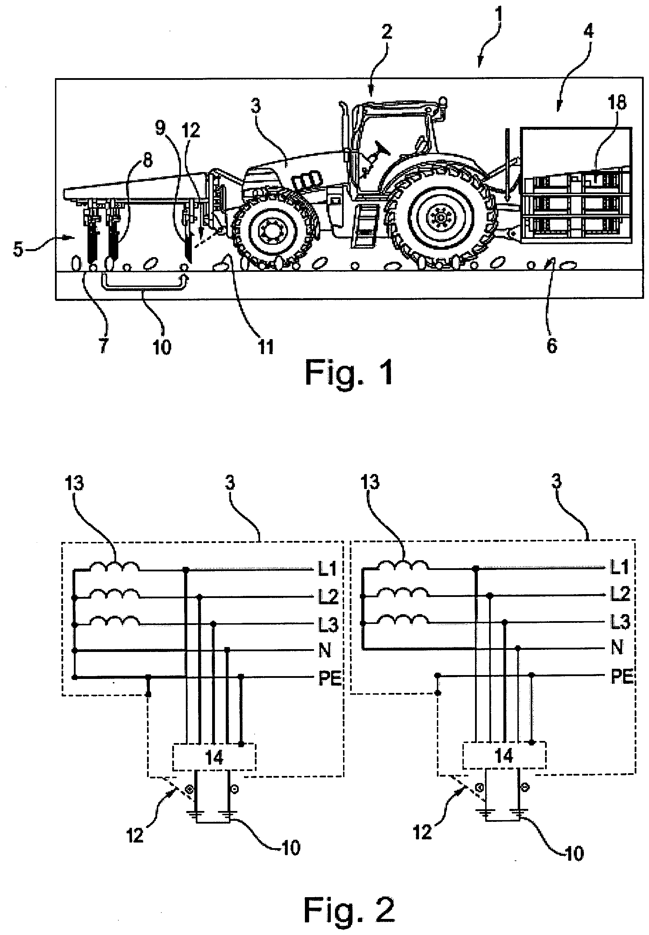

Die in Figur 1 gezeigte Vorrichtung 1 besteht im Wesentlichen aus den Trägerfahrzeug 2 mit dessen Chassis 3, einer Hochspannungseinrichtung 4 und Hochspannungselektroden 5. Diese Vorrichtung 1 dient der Behandlung des Bodens 6, wobei mit der Hochspannungseinrichtung 4 eine Hochspannung erzeugt wird, die über die Hochspannungselektroden 5 in einen ersten Bodenbereich 7 eingeleitet wird. Da die Elektroden 8, 9 (nur beispielsweise beziffert) unterschiedlich gepolt sind, entsteht zwischen ihnen im ersten Bodenbereich 7 ein Nutzstrom 10, der eine Beeinträchtigung oder sogar Verhinderung des Wachstums von Pflanzen 11 (nur exemplarisch beziffert) bewirkt.

Bei derartigen Anordnungen kann zwischen den Hochspannungselektroden 5 und dem Chassis 3 ein einpoliger Kurzschluss 12 entstehen, wie er hier zwischen dem Applikator 9 und dem Trägerfahrzeug 2 gezeigt ist.

Die Figur 2 zeigt anhand des Beispiels eines TN-S-Systems und eines IT-Systems, dass bei einem derartigen einpoligen Kurzschluss 12 zunächst kein Fehlerstrom detektierbar ist. Sowohl die üblicherweise eingesetzte RCD-Technik als auch die IMD-Technik, welche Fehlerströme auf der Niederspannungsseite detektieren, werden bei hochspannungsseitigen Kurzschlüssen nicht aktiv.

Im Einzelnen zeigt die Figur 2 jeweils einen Generator 13, ein Chassis 3, einen Transformator 14 und den Nutzstrom 10.

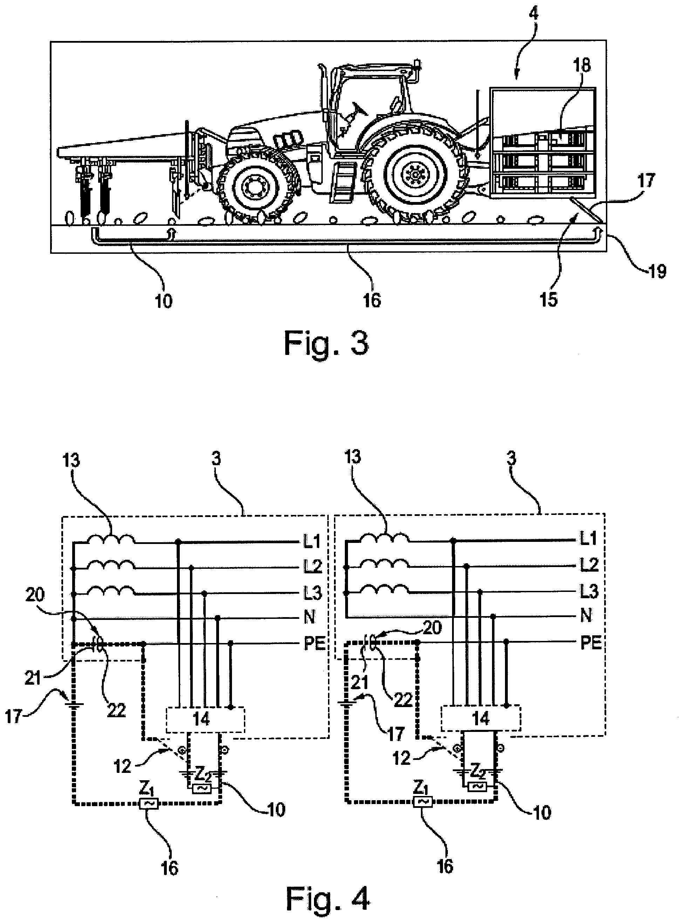

Das in Figur 3 gezeigte System entspricht den in Figur 1 gezeigten jedoch mit einer Erdung 15. Darüber hinaus zeigt die Figur 3 die Aufteilung zwischen Nutzstrom 10 und Fehlerstrom 16. Dafür erstreckt sich eine Erdungskette 17 von der Hochspannungseinrichtung 4 mit den Transformatoren 18 zu einem zweiten Bodenbereich 19. Die Fehlerstrommessung 20 besteht aus einer Messeinrichtung 21, die den Erdstrom misst, und einer Auswerteelektronik 22.

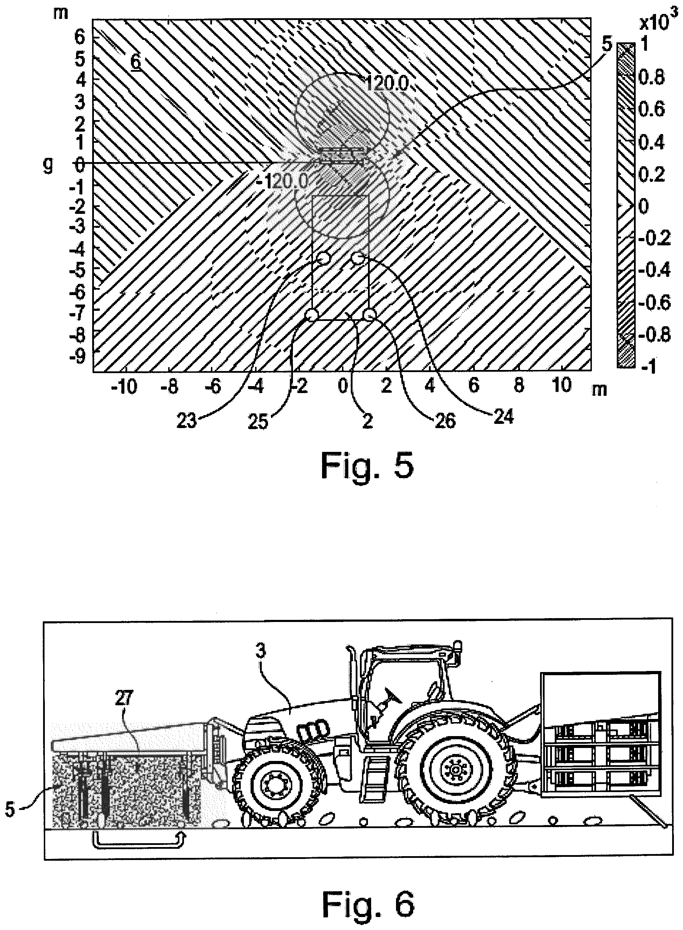

Die Figur 5 zeigt den entstehenden Spannungstrichter anhand eines Beispiels mit Gleichspannung. Die Elektroden haben elektrische Potentiale von +/- 1 kV, einen Abstand von 0,5 m, eine Auflagefläche von 0,2 m$^2$ (2 m x 0,1 m) und der Übergangswiderstand wird nicht betrachtet. Mittels Äquipotentiallinien sind jeweils die Grenzwerte +/- 120 V dargestellt. Die untere Kante der negativen Elektrode (- 1 kV) befindet sich an der y-Koordinate 0 m. Der Abstand zwischen dem Applikator 9 und der Erdung an dem Trägerfahrzeug 2 sollte in diesem Beispiel mindestens etwa 3,5 m betragen. Daher wurden mehrere Erdungspunkte 23 bis 26 mit räumlicher Verteilung beabstandet von den Hochspannungselektroden 5 am Trägerfahrzeug 2 vorgesehen.

Die Figur 6 zeigt, wie die Elektroden 5 in einem isolierten Applikatorraum 27 angeordnet sind. Dadurch wird ein einpoliger Kurzschluss zwischen den Hochspannungselektroden 5 und dem Chassis 3 des Trägerfahrzeugs 2 vermieden.

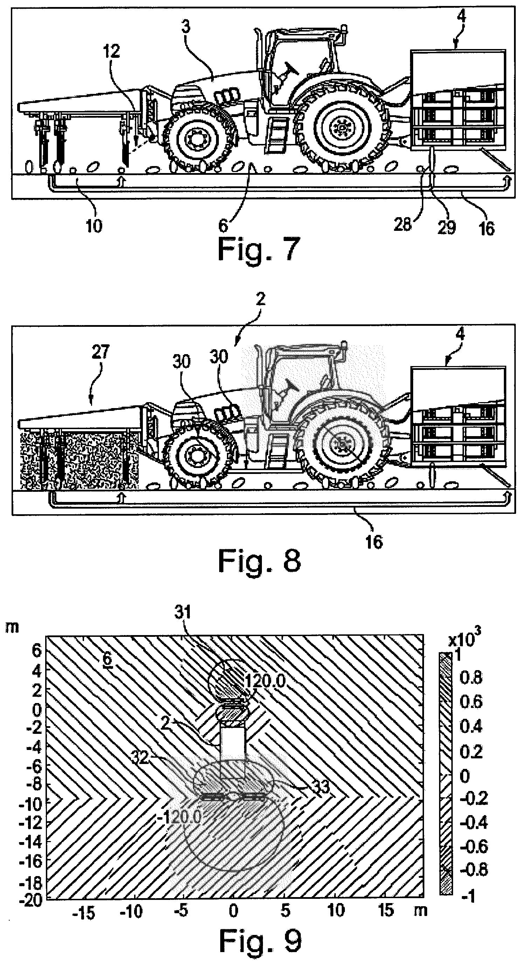

Die Figur 7 zeigt neben dem Nutzstromfluss 10 den detektierbaren Fehlerstrom 16. Hoher Bodenbewuchs 28 kann zwischen dem Boden 6 und dem Chassis 3 oder der Hochspannungseinrichtung 4 zu einem durch die Fehlerstrommessung 20 nicht detektierbaren Strom 29 führen.

Daher zeigt die Figur 8 an der Unterseite des Trägerfahrzeugs 2 eine elektrische Isolation 30, die sich vom Applikatorraum 27 an der Unterseite des Trägerfahrzeugs 2 bis zur Unterseite der Hochspannungseinrichtung 4 erstreckt. Dies führt dazu, dass kein nicht detektierbarer Strom 29 mehr vorliegt und der gesamte Fehlerstrom 16 detektierbar ist.

Die Figur 9 zeigt an der Potenzialverteilung auf der Bodenoberfläche bei anliegenden elektrischen Potentialen von +/- 1 kV das Einleiten von Hochspannung in den Boden 6 mit Hochspannungselektroden 31 vor dem Trägerfahrzeug 2 und Hochspannungselektroden 32, 33 seitlich des Trägerfahrzeugs 2 als Flügelanordnung. Erdungselemente können grundsätzlich an jeder Position montiert werden und können als Abstandshalter oder Abstandssignalisierung verwendet werden. Die Erdungselemente können auch als Feldsteuerelektrode zur Schrittspannungsreduzierung eingesetzt werden.

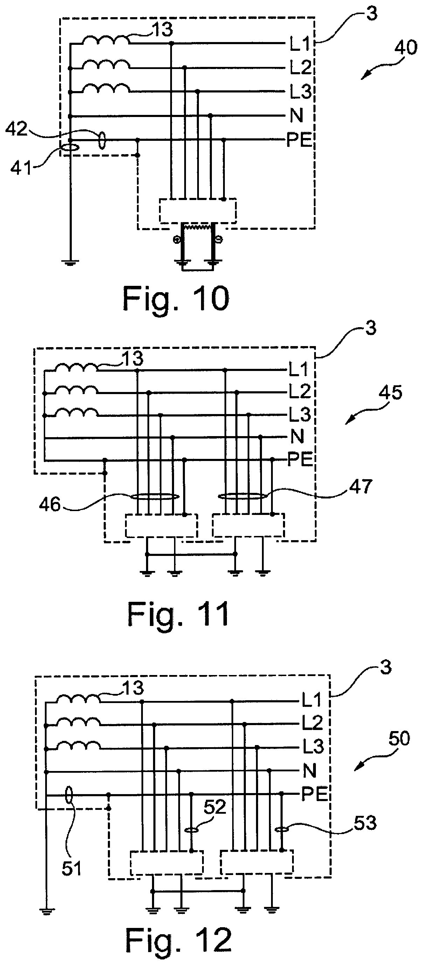

Zur Erfassung der Fehlerströme können bei der in Figur 10 gezeigten Schaltung 40 z.B. die Positionen 41 und 42 verwendet werden. Mittels Position 41 können neben der reinen Isolationsfehlermessung auch weitere Ableitströme erfasst werden. Jede Meldung eines Isolationsfehlers muss zum sicheren Abschalten des Gesamtsystems führen. Zur ausschließlichen Erfassung von Fehlerströmen kann parallel zur Fehlerstrommessung ein Filter (z.B. kapazitiv, nicht gezeigt) geschaltet werden. Dieser kann zur Separierung von Fehlerströmen und betriebsbedingten Ableitströmen verwendet werden, um sicherzustellen, dass die Fehlerstromdetektion nicht bei betriebsbedingten Ableitströmen auslöst.

Die Figur 11 zeigt in der Schaltung 45 die Verwendung von RCM-Technik zum Detektieren von niederspannungsseitigen Isolationsfehlern bei der Verwendung mehrerer Umrichter am Beispiel eines TN-Netzes. Die Sensoren 46 und 47 können dabei allstromsensitiv ausgeführt werden.

Die Figur 12 zeigt eine Anordnung 50 zum Detektieren von hochspannungsseitigen Isolationsfehlern. Sensor 51 dient dabei wie oben beschrieben zum Detektieren von Isolationsfehlern zwischen dem HV-Ausgang der Umrichter und dem Chassis. Sensor 52 und Sensor 53 dienen der Ortung von Isolationsfehlern zwischen dem HV-Ausgang und dem Gehäuse des Umrichters und werden entsprechend zu Sensor 51 ausgeführt. Der Sensor 51 löst bei dieser Art des Fehlers ebenfalls aus. Löst ausschließlich Sensor 51 aus, kann davon ausgegangen werden, dass sich der Fehler außerhalb des Umrichters befindet. Bei Verwendung nur eines Umrichters kann zwischen einem Fehler am Umrichter und einem Fehler im restlichen System unterschieden werden.

Beide Fehlerdetektionsmaßnahmen (NV-Ortung, HV-Ortung) können parallel installiert werden.

Bei der Verwendung von mehr als einem Umrichter ist stets ein Pol zu überbrücken, um eine Reihenschaltung von Umrichtern zu verhindern. Diese Reihenschaltung würde nicht zulässige Potentialanhebungen im System erzeugen und ggf. zu Materialschädigungen führen. Eine Reihenschaltung kann durch Verbindung eines Minusausgangs eines Umrichters mit einem Plusausgang eines anderen Umrichters auftreten und bspw. durch Metallgegenstände auf dem Untergrund erzeugt werden.

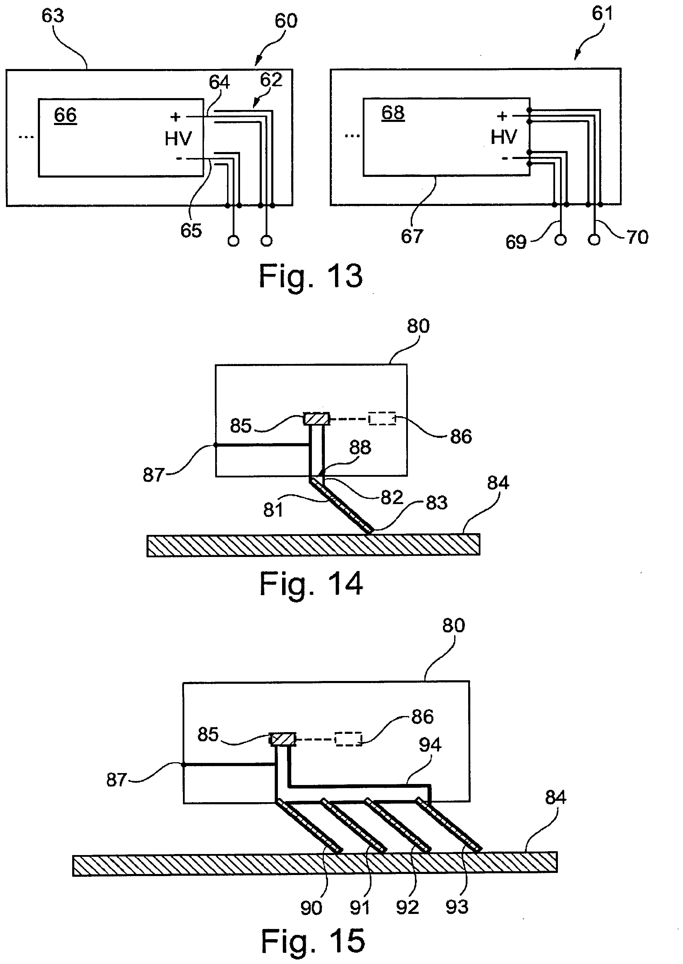

Eine beidseitig aufgelegte HV-Schirmung der HV-Kabel würde die Voraussetzung für die Fehlerortung verletzen. Bei Verwendung einer Schirmung (z.B. aus EMV-Gründen) ist ein einseitiges Auflegen notwendig, um die Isolation zwischen Umrichtergehäuse und Chassis zu gewährleisten. Die nicht aufgelegte Seite muss gegenüber dem Chassis/Umrichtergehäuse hochohmig isoliert ausgeführt werden. Hier kann grundsätzlich zwischen den zwei in Figur 13 gezeigten Anordnungen 60 und 61 gewählt werden:

Wird die HV-Schirmung 62 auf das Chassis 63 gelegt, kann zwischen einem HV-Isolationsfehler des Kabels 64, 65 gegenüber einem internen HV-Isolationsfehler des Umrichters 66 unterschieden werden. Das fehlerhafte Kabel kann nicht identifiziert werden.

Bei Verwendung einer einseitigen Auflage auf das Gehäuse 67 des Umrichters 68, kann bei einem HV-Isolationsfehler der fehlerhafte Umrichter 68 inkl. Kabel 69, 70 identifiziert werden. Es kann nicht unterschieden werden, ob der Fehler im Umrichter 68 oder in einem der Kabel 69, 70 vorliegt.

Da ein Verlust der Erdungselemente oder eine fehlerhafte Inbetriebnahme dazu führen kann, dass das Chassis nicht geerdet ist, wird im Folgenden eine Überwachung der Erdung beschrieben.

Die Figur 14 zeigt den schematischen Aufbau einer Schleifenüberwachung. Hier ist als Chassis 80 schematisch der Heckrahmen von Figur 1 dargestellt. Grundsätzlich kann das Konzept jedoch an einer beliebigen Stelle der Vorrichtung integriert sein. Es wird parallel zum Erdungselement 81 ein Kabel 82 (bzw. ein elektrischer Leiter/Rückleiter) verlegt, welches zum Erdungselement 81 elektrisch isoliert ausgeführt ist. Erst an der Stelle 83, wo das Erdungselement den Boden 84 berührt (bzw. möglichst nah an der Stelle) wird das Kabel 82 mit dem Erdungselement 81 elektrisch verbunden. Dies stellt sicher, dass auch ein teilweiser Verlust des Erdungselementes 81 detektiert wird. In einem Fehlerfall wird der Ruhestromkreis unterbrochen und die Elektronik der Schleifenüberwachung 85 meldet einen Fehler an die SPS der zweiten Schleifenüberwachung 86. Diese kann dann die Hochspannung an den Elektroden abschalten und das System in einen sicheren Zustand bringen. Es besteht ausschließlich eine einzige elektrische Verbindung 87 zum Chassis 80. Am Durchgang des Kabels 82 durch das Chassis 80 ist eine elektrische Isolation 88 vorgesehen.

Die Figur 15 zeigt eine mögliche Verschaltung bei Verwendung mehrerer Erdungselemente 90, 91, 92, 93. Dazu werden die Erdungselemente in Reihe geschaltet. Dies stellt sicher, dass jeder Verlust eines beliebigen Erdungselements die Erdschleife 94 unterbricht und eine Fehlerdetektion stattfindet. Grundsätzlich ist auch eine Parallelschaltung möglich.

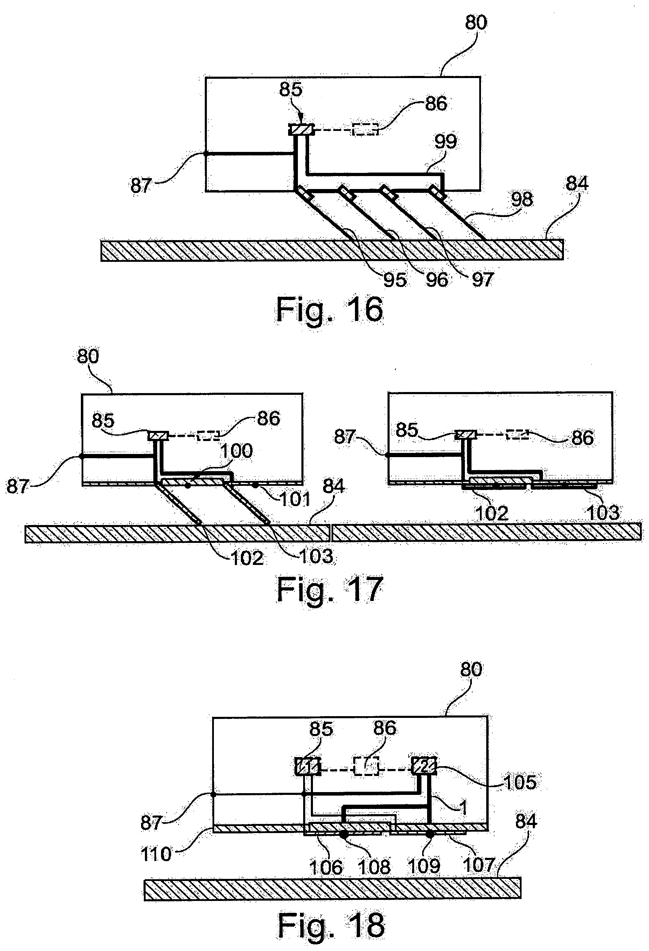

Ist kein Verlust des Erdungselements zu erwarten, kann wie in Figur 16 gezeigt auf dieselbe Art und Weise eine Montage- bzw. Demontageüberwachung durchgeführt werden. Dabei kann die Verbindung zwischen Erdungselement 95, 96, 97, 98 und dem als Rückleiter dienenden Kabel 99 nahe dem Rahmen des Chassis 80 durchgeführt werden.

Die Figur 17 zeigt, wie die Handhabung durch Verwendung von gegenüber dem Chassis isolierten Befestigungspunkten 100 und 101 vereinfacht werden kann. Diese Befestigungspunkte 100, 101 dienen dazu, die Erdungselemente 102, 103 für den Transport zu fixieren. Wird das Gesamtsystem für den Betrieb vorbereitet, muss der Inbetriebnehmer die Erdungselemente 102, 103 manuell lösen oder das Lösen wird von dem System automatisiert durchgeführt. Dabei kann das Lösen der Befestigungen nicht oder nicht vollständig, bzw. fehlerhaft durchgeführt werden.

Die Figur 18 zeigt eine erste Schleifenüberwachung 85 und eine zweite Schleifenüberwachung 105 als Befestigungsüberwachung, um die Befestigung der Erdungselemente 106 und 107 an Befestigungspunkten 108, 109 zu überwachen. Dazu sind die Befestigungspunkte 108, 109 mit einer Isolierung 110 elektrisch vom Chassis 80 isoliert. Die Befestigungspunkte 108, 109 sind bei ihrer Verwendung elektrisch mit den Erdungselementen 106, 107 verbunden und sie befinden sich in ausreichendem Abstand zu den Aufhängungen (nicht gezeigt) der Erdungselemente, um eine elektrische Verbindung zwischen diesen (bei nicht fixierten Erdungselementen) zu verhindern. Die Befestigungspunkte 108, 109 können grundsätzlich an jeder Position am Rahmen des Chassis 80 installiert sein. Mehrere Befestigungspunkte 108, 109 sind dabei parallelgeschaltet, um sicherzustellen, dass alle Befestigungspunkte ordnungsgemäß gelöst wurden. Die Befestigungspunkte müssen sich nicht an der Unterseite des Rahmens befinden.

Wird das Gesamtsystem fehlerfrei in Betrieb genommen, fließ kein Ruhestrom im zweiten Stromkreis 111. Befinden sich die Erdungselemente in der Fixierung, fließt ein Ruhestrom im zweiten Stromkreis und ein Anlaufen des Gesamtsystems kann nicht durchgeführt werden. Die SPS 86 bekommt im Fehlerfall eine Meldung der Elektronik der zweiten Schleifenüberwachung, welche die Inbetriebnahme verhindert.

Die Überwachungskreise arbeiten unabhängig voneinander und können einzeln verwendet werden. Es ist sicherzustellen, dass jeweils eine Verbindung 87 zum Chassis 80 besteht.

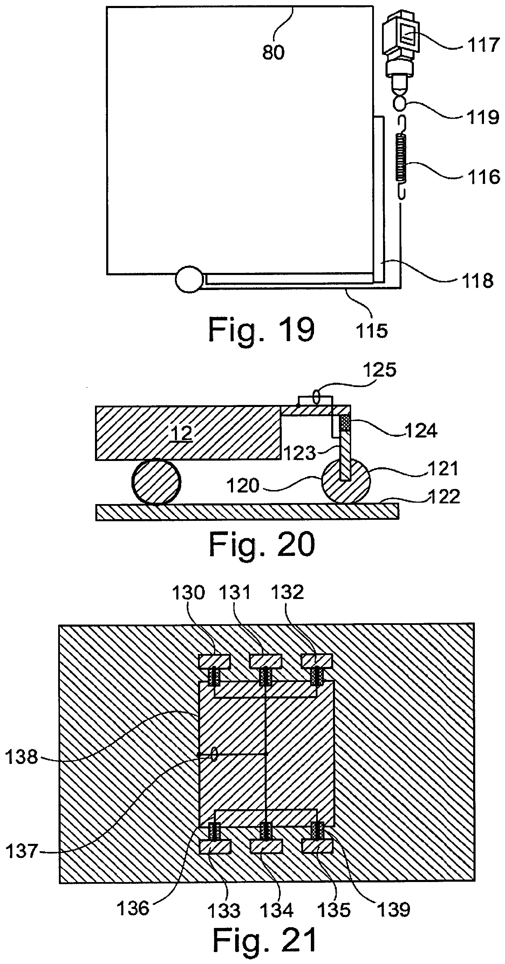

Eine weitere Möglichkeit der Transportsicherung mit Überwachung ist in Figur 19 dargestellt. Dabei wird das Erdungselement 115 zum Transport über ein Federelement 116 (optional) mit einem Befestigungspunkt 119 eines Seilzugschalters 117 oder eines Hebelschalters manuell verbunden. Dadurch ist eine definierte Verlegung des Erdungselements 116 gewährleistet. Es kann ebenfalls ein Seilzugschalter in Kombination mit einem Hebel verwendet werden. Der Schalter 117 ist dabei am Rahmen des Chassis 80 oder des Anbaugeräts befestigt. Grundsätzlich ist die Positionierung des Schalters 117 beliebig und hängt von der Länge des Erdungselementes 115 ab. Der Schalter 117 verfügt über eine automatische Rückstellung (Taster). Zwischen dem Rahmen des Chassis 80 und dem Erdungselement 115 kann ein mechanischer Abstandshalter 118 als Schutz hinzugefügt werden.

Sollte nach dem Transport das Gesamtsystem für den Betrieb vorbereitet werden, muss das Erdungselement 115 von dem Federelement 116, bzw. dem Schalter 117 manuell oder automatisiert getrennt werden. Sollte dies nicht oder fehlerhaft passieren, wird dies vom Schalter 117 detektiert und zu einer speicherprogrammierbaren Steuerung 86 weitergeleitet. Diese kann dann das Anlaufen des Gesamtsystems verhindern und dem Betreiber eine Fehlermeldung und/oder einen Handlungshinweis geben. Die Befestigung des Erdungselements 115 über den Seilzugschalter 117 sollte dabei die einzige Möglichkeit sein, das Erdungselement 115 zu befestigen.

Die Figur 20 zeigt, wie die Räder 121 als Erdungselement oder als Rückleiter (bzw. Elektroden) verwendet werden können. Die Fläche 120, mit der das Rad 121 den Boden 122 berührt, hat eine elektrische Verbindung zum Fahrgestell 123 (ggf. mit Schleifringkontakten). Das Fahrgestell 123, welches in elektrischer Verbindung mit dem Rad 121 steht, besitzt eine hochspannungsfeste Isolation 124 zum Rahmen des Chassis 126. Diese Isolation 124 ist entsprechend der höchsten im System auftretenden Spannung ausgelegt. Das Rad 121 kann zur besseren elektrischen und mechanischen Anbindung an den Boden 122 ein Profil besitzen. Bei der Konstruktion sind grundsätzlich normgerechte Kriech- und Luftstrecken einzuhalten. Die Isolation 124 wird über eine Fehlerstrommessung 125 überbrückt.

Die Figur 21 zeigt, wie bei einer Verwendung von mehr als einem Stützrad 130 bis 135 eine Verschaltung der Potentialausgleichskabel oder Erdungskabel 136 aufgebaut werden kann. Dies ermöglicht einen Stromfluss zwischen den Stützrädern 130 bis 135 ohne das Auslösen einer Fehlerstromüberwachung. Dabei werden die Räder parallelgeschaltet. Es besteht ausschließlich eine einzige Verbindung 137 zum Rahmen oder Chassis 138. Durch diese Verbindung kann der Fehlerstrom detektiert werden. Die Potentialkabel und Erdungskabel 136 sind gegen das Chassis 138 über Isolationshülsen 139 (nur exemplarisch beziffert) isoliert.

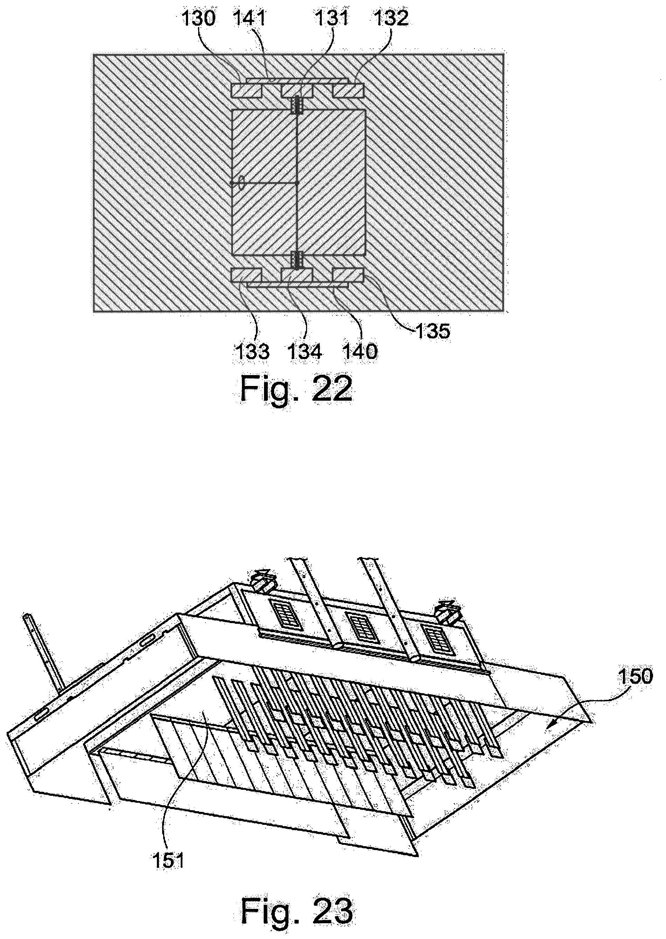

Besteht zwischen den Rädern 130 bis 135 eine elektrische Verbindung wie z.B. über das Fahrgestell 140, 141 kann, wie in Figur 22 gezeigt, der Verkabelungsaufwand reduziert werden.

Für die Isolation des Applikationsraums 150 zum Rahmen eines Chassis 3 kann hochspannungsfester Kunststoff verwendet werden. Die Figur 23 zeigt, wie eine Kunststoffbaugruppe 151 so konstruiert werden kann, dass es keine direkte Verbindung zwischen Applikationsbereich und restlicher Maschine, wie insbesondere dem Chassis 3 gibt. Luft- und Kriechstrecken werden eingehalten. Alle Befestigungen sind als Sacklochbohrungen ausgeführt. Sollte durch Vibrationen oder Pflanzen die Verkabelung beschädigt oder gar abgerissen werden, bleibt der Fehler im Hochspannungsbereich.

Als weitere Sicherheitsmaßnahme zur Vermeidung von nicht zulässigen elektrischen Potentialen auf dem Rahmen des Chassis 3 kann der gesamte Frontrahmen aus nichtleitendem Material aufgebaut werden (z.B. GFK). Bei Fahrzeugen kann das gesamte Chassis aus nicht leitendem Material aufgebaut werden (z.B. autonome Fahrzeuge).

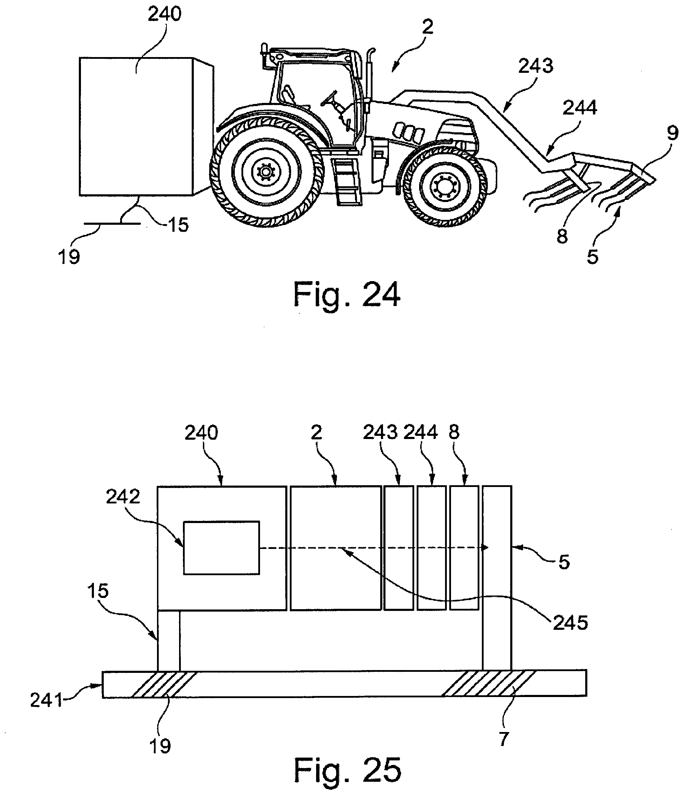

In den Figuren 24 und 25 sieht man die Erdung 15 zwischen einer Plattformversorgung 240 und dem Bodenbereich 19 des Bodens 241. Die Plattformversorgung 240 ist auf eine Leistungsklasse ausgelegt, die angibt, wie viele Elektroden angeschlossen werden können, und enthält das Gehäuse 242 der elektrischen Komponenten (Generator, HV-Module, HV-Kabelschirm). Das Trägerfahrzeug 2 hat eine Aufnahme 243 für Anbaugeräte mit einem Adapter 244, der die Applikatoren 8, 9 hält, an denen Elektroden 5 befestigt sind. Dabei ist die Aufnahme 243 für Anbaugeräte eine mechanische Vorrichtung, die die Applikatoren 8, 9 trägt und sie mit dem Trägerfahrzeug 2 verbindet. Der Adapter 244 ist eine mechanische Vorrichtung, die verwendet wird, um ein herkömmliches Trägerfahrzeug 2 an spezielle Applikatoren 8, 9 anzupassen. Ein Applikator 8, 9 ist eine mechanische Vorrichtung die mindestens eine Elektrode 5 trägt. Eine Elektrode ist ein Teil, das Hochspannung führt und so angeordnet ist, dass es bei der Verwendung der Vorrichtung eine Pflanze oder den Bodenbereich 7 berührt.

Das HV-Kabel 245 führt vom Gehäuse 242 über das Trägerfahrzeug 2, die Aufnahme 243, einen Adapter 244, Applikatoren 8, 9 bis zu den Elektroden 5.

Zwischen jedem der in der Figur 25 gezeigten Elemente kann eine Isolierung angeordnet sein. Dabei kann eine Mehrfachisolierung durch eine Spannungsmessung überwacht werden. Zwischen den Elementen kann auch eine definierte, überwachte elektrische Verbindung zur Fehlerstrommessung angeordnet sein. Schließlich kann zwischen den Elementen auch eine elektrische Verbindung ohne Überwachung angeordnet sein.

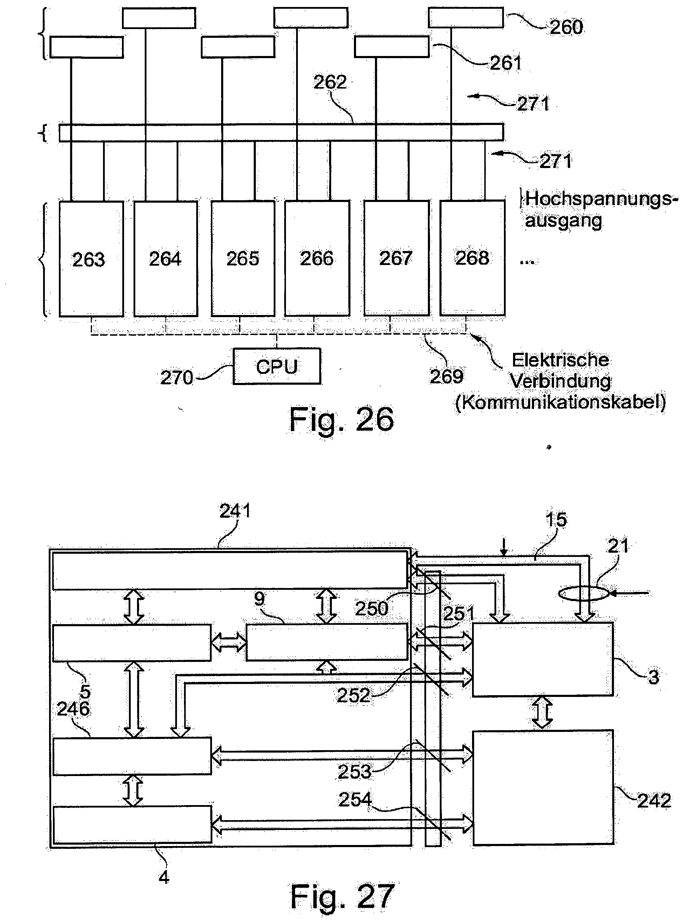

Die Figur 26 zeigt, wie eine Verteilung der Gesamtenergie über Module die Energie, die im menschlichen Körper umgewandelt wird, im Fehlerfall reduziert. Dafür sind eine erste und eine zweite Elektrodenreihe 260 und 261 mit Plus-Elektroden und eine gebrückte zweite Elektrodenreihe 262 mit Minus-Elektroden über Hochspannungskabel 271 als elektrische Verbindungen mit dem Hochspannungsausgang von modular, begrenzt und geregelten Hochspannungserzeugungsmodulen 263 bis 268 verbunden. Die Module stehen wiederum über Kommunikationskabel 269 als elektrische Verbindung mit einer CPU 270 in Verbindung.

Wenn die Schaltung zwischen einem Pluspol und einem Minuspol von einem menschlichen Körper überbrückt wird oder nur teilweise, steht dieser Schaltung nur die Energie eines Moduls zur Verfügung, indem die Gesamtenergie geteilt wird. Grundlage dafür ist, dass die Leistung eines Moduls geregelt oder begrenzt wird. Die Module können ein- oder mehrpolig auf der Eingangsseite ausgeführt werden. Dies reduziert die Wahrscheinlichkeit eines tödlichen Fehlerstroms.

Ein weiterer Vorteil ist die höhere Ergebnisqualität hinsichtlich der biologischen Leistungsfähigkeit der Anwendung. Um den hohen Einschaltstrom bei gleichzeitigem Einschalten aller Module zu vermeiden, können diese mit einer Zeitverzögerung eingeschaltet werden. Aus praktischen Gründen sollte die Zeitverzögerung klein sein, damit die unbehandelte Oberfläche während des Einschaltvorgangs klein bleibt (System ist in Bewegung). Im Idealfall sollten alle Module nach 1s eingeschaltet werden.

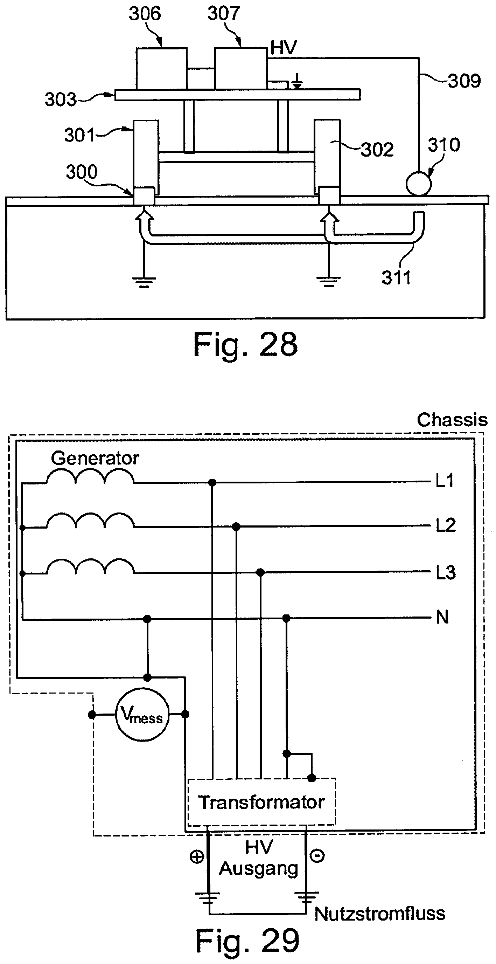

Die in den Figuren 27 und 28 gezeigte Struktur dient zur Erfassung von Fehlerströmen in Eisenbahnsystemen. Zu diesem Zweck wird das elektrische System an einer definierten Stelle mit dem Chassis verbunden, um die Fehlerstrommessung durchzuführen. Die Gehäuse der Aggregate sind vom Generator aus mit dem Gehäuse verbunden. Die HV-Kabel sind zur Fehlererkennung abgeschirmt und beschichtet.

Durch die Verwendung der Schienen 300, der darauf laufenden Räder 301 und 302 und des Chassis 303 als Rückleiter kann die biologische Leistung erhöht werden, indem die Impedanz, mit der die Aggregate konfrontiert sind, reduziert wird. Die Leistungsteile haben immer einen geerdeten Ausgang. Ein Isolationsfehler kann durch Kurzschlusserkennung erkannt werden.

In den Figuren sind eine Fehlerstrommesseinrichtung 304, eine Erdung 305, ein Generator 306, ein Spannungserzeuger 307, eine elektrische Isolation 308, abgeschirmte und isolierte Hochspannungskabel 309, Elektroden 310 sowie der elektrische Strom 311 gezeigt.

Um Isolationsfehler zwischen dem HV-Ausgang und einem vollisolierten System zu erkennen, wird eine Spannungsmessung (Vmess) verwendet, die für die im System vorhandenen maximalen Spannungen ausgelegt ist. Die dies zeigende Figur 29 entspricht im Wesentlichen den Figuren 2 und 4 und zeigt zusätzlich die Spannungsmessung 325. Jedes Signal eines Isolationsfehlers sollte zu einem sicheren Abschalten des gesamten Systems führen. Da das isolierte System sich durch kapazitive Kopplung bis zu einer AC-Hochspannung aufladen kann, muss das Gesamtsystem nach der höchsten Systemspannung ausgelegt sein. Zum Personenschutz kann ein RCD in der Nähe des Generators verwendet werden (topologieunabhängig). Auf die Verbindung vom Sternpunkt zum PE kann verzichtet werden.

Um eine weitere, dritte Isolationsebene zu schaffen, kann das Chassis des Aufsatzes vom Chassis des Trägerfahrzeugs isoliert konstruiert sein. Das Gehäuse der Komponenten und das Gerät können berührungssicher ausgeführt werden, um die Berührungssicherheit zu erhöhen. Der Applikator ist mit dem Gerät verbunden.

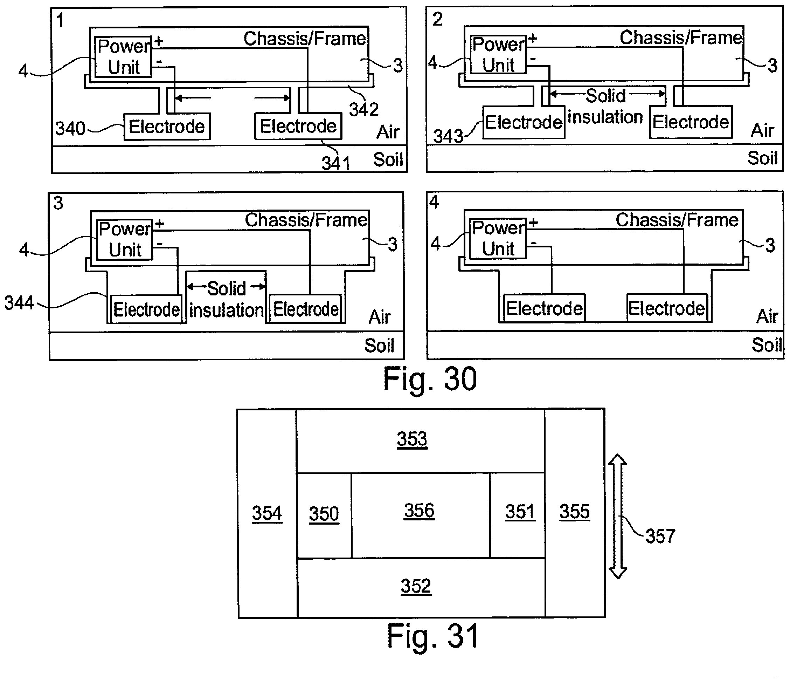

Weitere Verbesserungen betreffen die Isolierung der Elektroden. In der Figur 30 werden vier Konzepte vorgestellt, um die Elektroden vom Rest des Systems zu isolieren. Diese vier Konzepte unterscheiden sich in der Anordnung von Hochspannungs-Feststoffisolierung und Luftspalten. Aufgrund der möglichen Übertragung über den Untergrund (Vegetation) ist immer eine solide Isolierung (Basisisolierung) des gesamten Chassis / Rahmens dargestellt. Grundsätzlich können Systeme auch ohne Basisisolierung aufgebaut werden, wenn konstruktive Maßnahmen diesen Kontakt verhindern.

Das erste Konzept (1) beschränkt sich auf eine rein mechanische Fixierung der Elektroden 340, 341 über eine HV-Feststoffisolierung 342. Zwischen Elektrode und Chassis befinden sich nur die Basisisolierung und die Luftspalte, die entsprechend der Spannung und dem Verschmutzungsgrad ausgelegt sind. Diese Dämmstoffanordnung ist schwach, sobald auf die Basisisolierung verzichtet wird.

Das zweite Konzept (2) beinhaltet zusätzlich eine solide Isolierung 343 um die Elektroden herum. Diese Anordnung hat je nach Geometrie den Vorteil, dass die Luftstrecken kürzer sein können.

Das dritte Konzept (3) verzichtet zu Gunsten einer weiteren Feststoffisolation 344 vollständig auf die Gestaltung der Luftspalte zwischen den Elektroden und dem Chassis. Dadurch kann die Komplexität des Systems erhöht werden.

Das vierte Konzept (4) beinhaltet die vollständige Einbeziehung der Elektroden in eine feste Isolierung 345 (außer Unterboden). Der Nachteil ist, dass die tangentiale Grenzschicht (feste Isolation vs. Luftspalt) zwischen den Elektroden ein Schwachpunkt des Systems ist.

Ein weiteres Problem bildet die Gefahr des direkten menschlichen Kontaktes. Hierfür wird zunächst eine Näherungssperre vorgestellt.

Ein Sicherheitsabstand wird durch die Bedingung definiert, dass die Elektroden während des Betriebs nicht berührbar sind, d.h. dass sich niemand dem Hochspannungsbereich nähern darf. Darüber hinaus hat die Potentialverteilung in der Erde einen Einfluss auf die Schrittspannung. Weit entfernt vom Anwendungsbereich ist dieser jedoch so klein, dass keine weitere Überwachung oder Abschaltung erforderlich ist. Die Figur 31 zeigt einen ersten Gefahrenbereich 350, 351, einen zweiten Gefahrenbereich 352, 353 und einen dritten Gefahrenbereich 354, 355, die um den Anwendungsbereich 356 in der Bewegungsrichtung 357 angeordnet sind. Der zweite Gefahrenbereich 352, 353 ergibt sich aus der Überlegung, dass sich vor und hinter dem Vorderrahmen im Fahrsystem intuitiv kein Körper befindet, da der Fahrer vom fahrenden Trägerfahrzeug offensichtlich ist. Dieser Bereich wird daher vom Fahrer überwacht und nicht zusätzlich blockiert. Da die Dichte der Potentialausgleichsleitungen in den meisten Anwendungen an der Seite des Frontrahmens im Erdreich am höchsten ist und ein direkter Kontakt mit den Elektroden nicht ausgeschlossen werden kann, kann der erste Gefahrenbereich 350, 351 entsprechend definiert werden. Die drei Gefahrenbereiche gelten für jeden Anwendungsbereich einer Maschine. Es ist nicht erforderlich, einen Not-Aus-Schalter in der Nähe dieses Anwendungsbereichs zu installieren, der sich in der ersten oder der zweiten Gefahrenzone befindet. Auch der dritte Bereich sollte im Gefahrenfall nicht betreten werden.

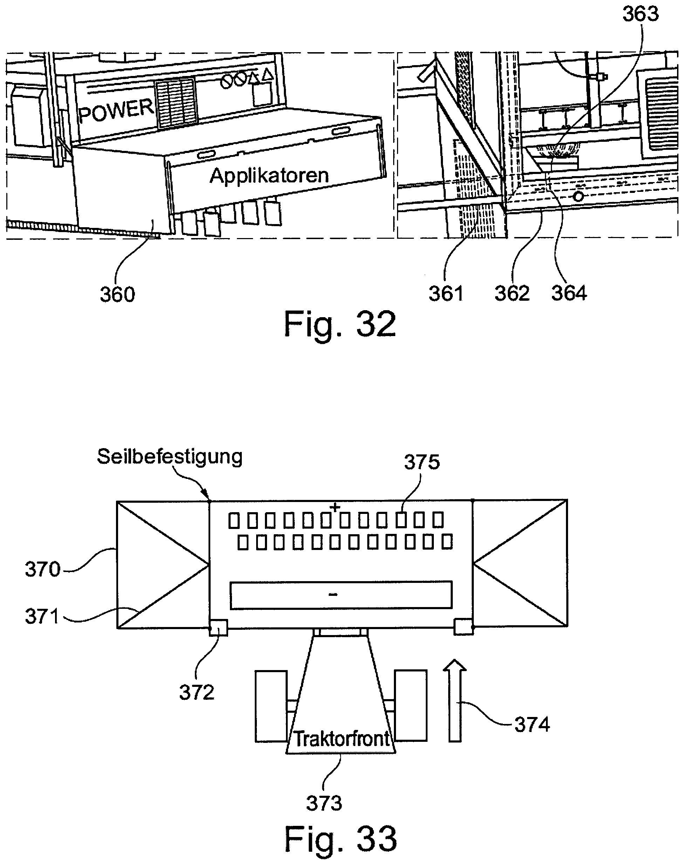

Die Figur 32 zeigt die Umsetzung der Sperrung des ersten Gefahrenbereichs 350, 351 durch einen ausfahrbaren Seitenschutz 360 (der Seitenschutz ist in der Figur ausgefahren). Die Abgrenzung der Gefahrenzone kann nur erfolgen, wenn sich in dieser Zone keine hohen Pflanzen befinden (z.B. Obstgärten, Weinberge). Die Barriere besteht aus mindestens einem Gestänge 361, das in den Rahmen 362 einschiebbar oder für den Transport zusammenklappbar ist. Darüber hinaus können redundant ausgelegte Sensoren 363 mit Magnet 364 verwendet werden, um den Status (ein- oder ausgefahren) zu erfassen und zu melden, z.B. an eine Sicherheits-SPS. Mindestens die Stufe C in der Sicherheitsbewertung kann erreicht werden. Der Rahmen 362 kann mit mindestens einer Matte abgedeckt werden.

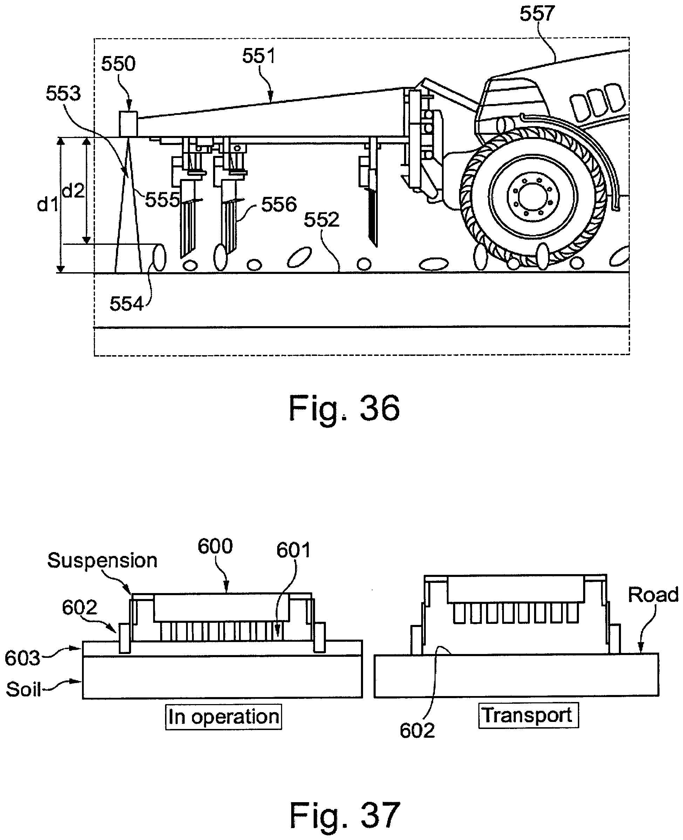

Eine weitere Möglichkeit, den ersten Gefahrenbereich 350, 351 abzuschotten, besteht darin, mindestens ein Seil 370 in Kombination mit einem Gestänge 371 und mindestens einem Seilzugschalter 372 zu verwenden. Dies ist in der Figur 36 an einer Traktorfront 373 gezeigt, die in Fahrtrichtung 374 einen Frontrahmen 375 bewegt.

Die Sicherstellung des Pflanzen- oder Erdungskontakts der Elektroden während des Betriebs ist eine weitere Hürde, die es erschwert, die Elektroden während des Betriebs zu berühren. Um die Sicherheitsvorkehrungen der Anbauteile unabhängig vom Trägerfahrzeug zu gewährleisten, werden als Zielpositionierung mehrere kombinierbare Lösungen vorgestellt. Die Hochspannung kann nur eingeschaltet werden, wenn der/die Sensor(en) die Zielposition der Elektroden bestätigen. Wird die Zielposition der Elektroden während des Betriebs verlassen, wird die Hochspannung abgeschaltet.

Eine Überwachungseinrichtung der Oberlenkerposition hat eine Verbindung sowohl zum Oberlenker als auch zum Vorderrahmen. Ein Sensor wird geschaltet, sobald sich der Vorderrahmen in der Zielposition befindet, mittels eines Rahmens, der sich in Abhängigkeit vom Winkel zwischen den beiden Elementen selbst einstellt. Eine Torsionsfeder kann die Mechanik dauerhaft in Richtung Traktor gegen einen Anschlag drücken, der in einer Längsnut fixiert ist. Am äußersten Punkt der Mechanik kann ein codierter RFID-Sensor mit Level D Freigabe angeordnet sein. Ein zweiter Arm kann ebenfalls drehbar auf dem Mechanismus montiert sein. Das Stellglied befindet sich am äußersten Punkt dieses Arms. Der Arm ist beispielsweise mit einem Gummiband am Oberlenker des Traktors befestigt, so dass er sich bewegt, wenn sich das Gestänge vom Traktor aus bewegt. Alternativ können auch andere Schalter verwendet werden.

Die Oberlenker-Positionsüberwachung hat dann mindestens eine Verbindung zum Oberlenker sowie zum Rahmen der Anwendung. Optional verfügt sie über mindestens eine Feder und einen Bewegungsmechanismus, der sich in Abhängigkeit vom Winkel zwischen Oberlenker und Rahmen verstellt. Die Oberlenker-Positionsüberwachung weist auch mindestens einen MikroSchalter oder Wegsensor auf, der die Zielposition erfasst. Grundsätzlich kann diese Anordnung an jeder beliebigen Stelle des Gesamtsystems angebracht werden, die für sie geeignet ist.

Die Positionierung eines Rahmens kann auch mit Hilfe von Neigungssensoren erfolgen. Grundsätzlich ist es möglich, nur einen (oder mehrere unabhängige Sensoren zur Erreichung der Redundanz) zu verwenden. Dieses Konzept funktioniert jedoch nur dann zuverlässig, wenn der Boden keine Neigung hat, da eine Änderung der Neigung auch die Neigung des Sensors verändert.

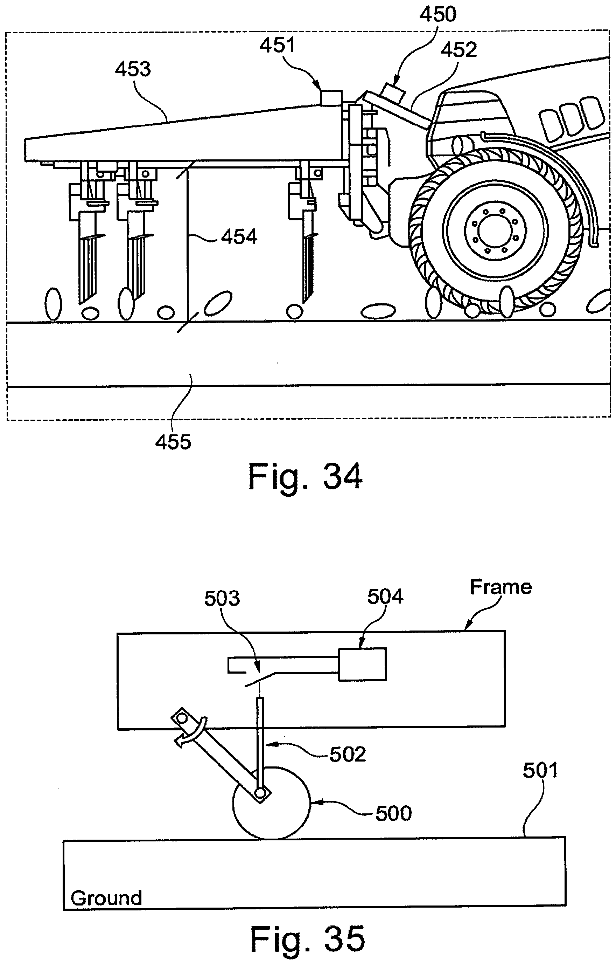

Zur Lösung dieses Problems können an verschiedenen Teilen der Struktur mindestens zwei Neigungssensoren 450, 451 angebracht werden, wobei die Differenz des Neigungswinkels ausgewertet wird. Die Figur 34 zeigt einen Sensor 451 am Rahmen 453 und einen Sensor 450 am Oberlenker 452. Da sich der Winkel der beiden Befestigungspunkte je nach Rahmenposition ändert, kann eine definierte Winkeldifferenz als Sollwert für die Rahmenhöhe 454 unabhängig vom Boden 455 verwendet werden.

Die Figur 35 zeigt eine Einrichtung zum Erfassen des Elektrodenstatus, um die Position einer beweglichen Elektrode zu erfassen. Die Elektrode 500 ist auf einer Aufhängung (nicht gezeigt) montiert, die es der Elektrode 500 ermöglicht, sich zu bewegen. Die Position der Elektrode 500 hängt davon ab, ob sich die Elektrode 500 am Boden 501 oder in der Luft befindet. Um diese Position zu erfassen, wird ein Hochspannungsisolierstab 502 verwendet, der den Status einer Taste 503 oder eines Drucksensors ändert. Diese Zustandsänderung wird von einem elektronischen Auswertesystem 504 erfasst. Nur wenn die Elektrode 500 mit dem Substrat des Bodens 501 in Kontakt steht, kann die Anwendung in Betrieb genommen werden. Wird der Erdungskontakt während des Betriebs gelöst, schaltet sich die Anwendung automatisch ab.

Eine Schaltung mit einer Plus- und einer Minuselektrode kann den biologischen Effekt der Anwendung bestimmen. Der Stromkreis wird erst geschlossen, wenn die Elektroden mit dem Substrat in Kontakt sind. Mit dieser Zustandsänderung kann mittels Leistungs- bzw. Strommessung festgestellt werden, ob sich die Elektroden in der Zielposition befinden, d.h. Massekontakt haben. Liegt an den Elektroden eine Spannung an und der gemessene Strom beträgt ca. 0 A, kann davon ausgegangen werden, dass das System nicht anwendungsbereit ist. Dies kann zwei Ursachen haben: Die Elektroden befinden sich nicht in der Zielposition oder die Masse ist zu hochohmig, um einen Stromfluss zu ermöglichen. In beiden Fällen ist eine Anwendung nicht wirksam. Zur Erzeugung eines Prüfstroms wird grundsätzlich nicht die volle Betriebsspannung benötigt. Die erforderliche Prüfspannung ergibt sich daraus, dass die Erdleitfähigkeit für die Anwendung unter einen bestimmten Wert fallen muss.

Zusammenfassend bedeutet dies, dass beim Einschalten der Prüfspannung ein Grenzwert für den aktuellen Durchfluss überschritten werden muss, um die Anwendung zu starten. Eine weitere Bestimmung der Prüfspannung kann sicherheitstechnische Einschränkungen darstellen. Wenn sich die Elektroden nicht in der Zielposition befinden, darf an den Elektroden auch keine gefährliche Prüfspannung anliegen. Aus diesem Grund kann die Prüfspannung eine hochfrequente Wechselspannung oder eine gepulste Spannung sein. Eine Leistungsbewertung während des Betriebs kann verwendet werden, um eine mögliche Abweichung von der Zielposition zu erkennen. Wird während der Anwendung ein Grenzwert nicht erreicht, wird der Betrieb automatisch beendet und der Anwender wird darüber informiert, dass entweder das Substrat zu hochohmig ist oder die Zielposition der Elektroden verlassen wurde.

Zur Messung der Rahmenhöhe kann auch mindestens ein Ultraschall- oder Radarsensor 550 am Rahmen 551 verwendet werden, der den Abstand zwischen dem Boden 552 und dem Rahmen 551 misst (siehe Figur 36). Dieser ist so am Rahmen 551 befestigt, dass das Messsignal 553 den Sensor 550 konstant in Richtung eines Objekts 554 am Boden 552 verlässt. Der Winkel zwischen Messsignal 553 und Boden 552 beträgt 90°. Bei Unebenheiten kann dieser Winkel um mehrere Grad abweichen. Grundsätzlich können mehrere Ultraschallsensoren an jedem Rahmen 551 verwendet werden, um eine Redundanz zu erreichen. Die Sensoren 550 können grundsätzlich in jeder Höhe des Rahmens 551 montiert werden und erfassen Objekte 554, die sich innerhalb des Messtrichters 555 befinden, mit einem weitgehend einstellbaren Wert zum Sensor.

Wenn der Boden 552 zugewachsen ist, kann zwischen verschiedenen Höhenniveaus unterschieden werden. Die Figur 36 unterscheidet zwischen dem Abstand zum Boden (d1) und dem Abstand zur Pflanze (d2). In den meisten Anwendungen ist die Höhe bis zum Boden entscheidend, da diese in der Regel für die Sicherheitsbewertung entscheidend ist. Die Höhe der Vegetation muss bekannt sein, um von d2 auf d1 zurückrechnen zu können. Grundsätzlich ist auch eine Anpassung ohne bekannte Höhe der Vegetation möglich. In diesem Fall ist die Referenzhöhe die Pflanzenhöhe.

Wird der Rahmen 600, der die Elektroden 601 enthält, nicht von einem Heber eines Antriebsfahrzeugs 557 gehalten, sondern hat eigene Räder 602, können diese höhenverstellbar ausgeführt werden (siehe Figur 37). Für den Transport (rechte Darstellung) können die Elektroden 601 so angehoben werden, dass sie während des Transports nicht den Boden 602 berühren. Darüber hinaus kann die Höhe der Elektroden 601 in Abhängigkeit von der Höhe und der Art der Vegetation 603 angepasst werden. Höhenverstellbare Räder 602 können an jeder beliebigen Stelle des Systems eingesetzt werden. Diese Einstellung beeinflusst den Anpressdruck auf die Pflanze, der je nach Anwendung unter anderem einen Optimierungsparameter darstellt.

Zusammenfassend ist somit festzuhalten, dass sich durch die Verwendung von nicht isolierter Hochspannung (Elektroden) Fragen bezüglich der Sicherheit im Hinblick auf Fehlererkennung und Vermeidung von Körperströmen sowohl bei direkter Berührung der Hochspannung als auch des Trägerfahrzeugs oder der Anbaugeräte stellen.

Hauptziel ist daher die Vermeidung von Hochspannung auf berührbaren Teilen. Um das zu verhindern dient eine einfache Hochspannungsisolierung der Spannungsquelle. Wenn diese Isolierung allerdings versagt, kommt es bis zu tödlichen Körperströmen bei Berührung. Die Lösung liegt in einer definierten Erdung mit Strommessung. Ein Fehler kann detektiert werden und das System kann abgeschaltet werden.

Aufgrund der Gegebenheiten des Untergrundes (hoher Bewuchs) kann auf dem Fahrzeug allerdings auch Hochspannung liegen, obwohl kein Isolationsfehler vorliegt. Nämlich dann, wenn Pflanzen sowohl die Hochspannungselektroden als auch das Fahrzeug berühren. Deshalb wird eine Isolation des Fahrzeugs, bzw. des Unterbodens vorgeschlagen.

Eine weitere MöglichkeitKörperströme bei Berührung des Fahrzeugs zu vermeiden ist eine zusätzliche Isolation, bspw. zwischen Applikator und Fahrzeug. Nun liegt trotz Isolationsverlust der ersten Isolation keine Hochspannung auf dem Fahrzeug. Das Fahrzeug kann also angefasst werden, ohne das ein Körperstrom fließt. Um den Fehler jetzt zu detektieren, nutzt die Erdung des Systems nichts. Es kann aber die Spannung zwischen Fahrzeug und Applikator gemessen werden, um den Fehler zu detektieren. Überschreitet die Spannung einen Grenzwert, wird abgeschaltet.

Näherungssperre, Sensor und Zielpositionserkennung sind notwendig, um den direkten Kontakt zum Menschen zu vermeiden.

## Patentansprüche

1. Vorrichtung (1) zur Behandlung eines Bodens (6), mit folgenden Elementen: einem Trägerfahrzeug (2), das ein Chassis (3) aufweist, einem Gehäuse (42) mit elektrischen Komponenten, einer Sicherheitsvorrichtung mit einer Hochspannungseinrichtung (4) zum Erzeugen einer Hochspannung, und Hochspannungselektroden (5), wobei die Sicherheitsvorrichtung aus einer Hochspannungsisolationsüberwachung und/oder einer mehrstufigen elektrischen Isolierung und/oder einem Näherungssensor und/oder einer Näherungsverriegelung und/oder einer Sollpositionserfassung besteht, wobei die Hochspannungselektroden (5) derart eingerichtet sind, dass die Hochspannung in einem ersten Bodenbereich (7) zur Unkrautinaktivierung mittels eines Nutzstroms (10) zwischen den Hochspannungselektroden (5) einleitbar ist, und die Sicherheitsvorrichtung eine Messeinrichtung (21) mit einer Auswerteelektronik (22) aufweist, um einen Fehlerstrom (16) oder eine Fehlerspannung zwischen einzelnen Elementen der Vorrichtung untereinander oder zwischen einzelnen Elementen und einer Erdung (15) zu messen, wobei die Erdung (15) zum Ableiten des Fehlerstroms (16) in einem zweiten Bodenbereich (19) dient und ein Abstand zwischen den Hochspannungselektroden (5) und der Erdung (15) mindestens 2 m beträgt.

2. Vorrichtung (1) nach Anspruch 1, *dadurch gekennzeichnet, dass* der Abstand zwischen den Hochspannungselektroden (5) und der Erdung (15) mehr als 3 m beträgt.

3. Vorrichtung (1) nach einem der vorhergehenden Ansprüche 1 oder 2, *dadurch gekennzeichnet, dass* die Erdung (15) eine Kette mit oder ohne daran befestigtem Kabel, mindestens ein Schneidelement und/oder leitfähige Matten aufweist.

4. Vorrichtung (1) nach einem der vorhergehenden Ansprüche 1 bis 3, *dadurch gekennzeichnet, dass* die Erdung (15) zum Ableiten des Fehlerstroms (16) in den zweiten Bodenbereich (19) mindestens ein Rad (121) aufweist, das elektrisch leitend mit dem Chassis (126) oder einem Anbauteil verbunden ist.

5. Vorrichtung (1) nach Anspruch 4, *dadurch gekennzeichnet, dass* das Rad (121) eine Bürste oder einen Schleifkontakt aufweist.

6. Vorrichtung (1) nach einem der vorherigen Ansprüche, *dadurch gekennzeichnet, dass* die Erdung (15), ein Element oder mehrere Elemente eine hochspannungsfeste Isolation (124) aufweist oder aufweisen.

7. Vorrichtung (1) nach einem der vorhergehenden Ansprüche, *dadurch gekennzeichnet, dass* die Erdung (15) zum Ableiten des Fehlerstroms (16) in den zweiten Bodenbereich (19) mehrere um mindestens 5 cm beabstandete Erdungspunkte (23 bis 26) zum Ableiten in unterschiedliche Bodenbereiche aufweist.

8. Vorrichtung (1) nach einem der vorhergehenden Ansprüche, *dadurch gekennzeichnet, dass* parallel zum Ableiten des Fehlerstroms ein Filter angeordnet ist.

9. Vorrichtung (1) nach einem der vorhergehenden Ansprüche, *dadurch gekennzeichnet, dass* einzelne Elemente, das Chassis, eine Aufnahme für Anbaugeräte, ein Adapter oder Applikatoren aus elektrisch isolierendem Material hergestellt sind, wobei der Adapter zwischen der Aufnahme und dem Applikator angeordnet ist.

10. Vorrichtung (1) nach einem der vorhergehenden Ansprüche, *dadurch gekennzeichnet, dass* zum Einleiten der Hochspannung in den ersten Bodenbereich (7) die Hochspannungselektroden (5, 31, 32 33) vor und seitlich des Trägerfahrzeugs (2) angeordnet sind.

11. Vorrichtung (1) nach einem der vorhergehenden Ansprüche, *dadurch gekennzeichnet, dass* die Vorrichtung (1) mindestens ein Rad (301, 302) aufweist, das elektrisch leitend für ein Abrollen auf einer Schiene (300) ausgebildet ist.

12. Vorrichtung (1) nach Anspruch 11, *dadurch gekennzeichnet, dass* ein Generator und ein Umrichter ausschließlich über eine elektrische Verbindung, insbesondere ein Kabel, mit dem Trägerfahrzeug ausgebildet als Zugfahrzeug elektrisch verbunden sind, welche zum Detektieren des Fehlerstroms genutzt wird.

13. Vorrichtung (1) nach einem der vorhergehenden Ansprüche, *dadurch gekennzeichnet, dass* die Vorrichtung (1) mehrere Sensoren (51, 52, 53) zum Detektieren von Isolationsfehlern aufweist, sodass die Erdung (15) zum Ableiten des Fehlerstroms (16) in den zweiten Bodenbereich (19) in Kombination mit den mehrere Sensoren (51, 52, 53) für eine Fehlerortung nutzbar ist.

14. Verfahren zum Betreiben einer Vorrichtung (1) nach einem der vorhergehenden Ansprüche, *dadurch gekennzeichnet, dass* das Einleiten der Hochspannung unterbrochen wird, wenn ein Erdstrom an einer Messeinrichtung (21) zum Messen eines Fehlerstroms oder einer Fehlerspannung einen Grenzwert überschreitet.

## Claims

1. Device (1) for treating soil (6), comprising the following elements : a carrier vehicle (2) which comprises a chassis (3), a housing (42) with electrical components, a safety device with a high-voltage device (4) for generating a high voltage, and high-voltage electrodes (5), wherein the safety device consists of a high-voltage insulation check and/or a multi-stage electrical insulation and/or a proximity sensor and/or a proximity lock and/or a setpoint position detection, wherein the high-voltage electrodes (5) are adapted so that the high voltage can be introduced into a first soil zone (7) for weed inactivation by means of a useful current (10) between the high-voltage electrodes (5), and the safety device comprises a measuring device (21) with evaluation electronics (22) for measuring a fault current (16) or a fault voltage between individual elements of the device or between individual elements and a grounding (15), wherein the grounding (15) serves to discharge the fault current (16) into a second soil zone (19) and a distance between the high-voltage electrodes (5) and the grounding (15) is at least 2 m.

2. Device (1) according to claim 1, *characterized in that* the distance between the high-voltage electrodes (5) and the grounding (15) is greater than 3 m.

3. Device (1) according to any one of the preceding claims 1 or 2, *characterized in that* the grounding (15) comprises a chain with or without a cable attached thereto, at least one cutting element and/or conductive mats.

4. Device (1) according to any one of the preceding claims 1 to 3, *characterized in that* the grounding (15) comprises at least one wheel (121) which is electrically conductively connected to the frame (126) or to an attachment, in order to conduct the fault current (16) into the second soil zone (19).

5. Device (1) as claimed in claim 4, *characterized in that* the wheel (121) comprises a brush or a friction contact.

6. Device (1) according to any one of the preceding claims, *characterized in that* the grounding (15), one element or more elements has or have high-voltage-resistant insulation (124).

7. Device (1) according to any one of the preceding claims, *characterized in that* the grounding (15) for discharging the fault current (16) in the second soil zone (19) comprises a plurality of grounding points (23 to 26) spaced apart by at least 5 cm for discharge into different soil zones.

8. Device (1) according to any one of the preceding claims, *characterized in that* a filter is arranged parallel to the discharge of the fault current.

9. Device (1) according to any one of the preceding claims, *characterized in that* individual elements, the frame, an accessory receptacle, an adapter or applicators are made of electrically insulating material, wherein the adapter is arranged between the receptacle and the applicator.

10. Device (1) according to any one of the preceding claims, *characterized in that*, for introducing high voltage into the first soil zone (7), the high-voltage electrodes (5, 31, 32, 33) are arranged at the front and side of the carrier vehicle (2).

11. Device (1) according to any one of the preceding claims, *characterized in that* the device (1) comprises at least one wheel (301, 302) configured to roll on a rail (300) in an electrically conductive manner.

12. Device (1) according to claim 11, *characterized in that* a generator and a converter are electrically connected exclusively via an electrical connection, in particular a cable, to the carrier vehicle configured as a towing vehicle, which is used to detect the fault current.

13. Device (1) according to any one of the preceding claims, **characterized in that** the device (1) comprises a plurality of sensors (51, 52, 53) for detecting insulation faults, so that the grounding (15) for discharging the fault current (16) into the second soil zone (19) can be used in combination with the plurality of sensors (51, 52, 53) for locating a fault.

14. Method of operating a device (1) according to any one of the preceding claims, *characterized in that* the introduction of the high voltage is interrupted when an grounding current at a measuring device (21) for measuring a fault current or a fault voltage exceeds a limit value.

**Revendications**

1. Dispositif (1) pour le traitement d'un sol (6), avec les éléments suivants : un véhicule porteur (2) qui présente un châssis (3), un boîtier (42) avec des composants électriques, un dispositif de sécurité avec un appareil à haute tension (4) pour générer une haute tension, et des électrodes à haute tension (5), le dispositif de sécurité étant constitué d'un contrôle d'isolation à haute tension et/ou d'une isolation électrique à plusieurs niveaux et/ou d'un capteur de proximité et/ou d'un verrouillage de proximité et/ou d'une détection de position de consigne, les électrodes à haute tension (5) étant adaptées de telle sorte que la haute tension peut être introduite dans une première zone de sol (7) pour l'inactivation des mauvaises herbes au moyen d'un courant utile (10) entre les électrodes à haute tension (5), et le dispositif de sécurité présentant un appareil de mesure (21) avec une électronique d'évaluation (22), pour mesurer un courant de défaut (16) ou une tension de défaut entre des éléments individuels du dispositif entre eux ou entre des éléments individuels et une mise à la terre (15), la mise à la terre (15) servant à évacuer le courant de défaut (16) dans une deuxième zone de sol (19) et une distance entre les électrodes à haute tension (5) et la mise à la terre (15) étant d'au moins 2 m.

2. Dispositif (1) selon la revendication 1, *caractérisé en ce que* la distance entre les électrodes à haute tension (5) et la mise à la terre (15) est supérieure à 3 m.

3. Dispositif (1) selon l'une quelconque des revendications 1 ou 2 précédentes, *caractérisé en ce que* la mise à la terre (15) présente une chaîne avec ou sans câble attaché à celle-ci, au moins un élément de coupe et/ou des tapis conducteurs.

4. Dispositif (1) selon l'une quelconque des revendications 1 à 3 précédentes, *caractérisé en ce que* la mise à la terre (15) présente au moins une roue (121) reliée de manière électriquement conductrice au châssis (126) ou à une pièce rapportée, afin d'évacuer le courant de défaut (16) dans la deuxième zone de sol (19).

5. Dispositif (1) selon la revendication 4, *caractérisé en ce que* la roue (121) présente un balai ou un contact frottant.

6. Dispositif (1) selon l'une quelconque des revendications précédentes, *caractérisé en ce que* la mise à la terre (15), un élément ou plusieurs éléments présente ou présentent une isolation (124) résistante aux hautes tensions.

7. Dispositif (1) selon l'une quelconque des revendications précédentes, *caractérisé en ce que* la mise à la terre (15) pour évacuer le courant de défaut (16) dans la deuxième zone de sol (19) présente plusieurs points de mise à la terre (23 à 26) espacés d'au moins 5 cm pour l'évacuation dans différentes zones de sol.

8. Dispositif (1) selon l'une quelconque des revendications précédentes, *caractérisé en ce qu*'un filtre est agencé parallèlement à l'évacuation du courant de défaut.

9. Dispositif (1) selon l'une quelconque des revendications précédentes, *caractérisé en ce que d*es éléments individuels, le châssis, un support d'accessoire, un adaptateur ou des applicateurs sont fabriqués en matériau électriquement isolant, l'adaptateur étant agencé entre le support et l'applicateur.

10. Dispositif (1) selon l'une quelconque des revendications précédentes, *caractérisé en ce que*, pour introduire la haute tension dans la première zone de sol (7), les électrodes à haute tension (5, 31, 32, 33) sont agencées à l'avant et sur le côté du véhicule porteur (2).

11. Dispositif (1) selon l'une quelconque des revendications précédentes, *caractérisé en ce que* le dispositif (1) présente au moins une roue (301, 302) configurée pour rouler sur un rail (300) de manière électriquement conductrice.

12. Dispositif (1) selon la revendication 11, *caractérisé en ce qu*'un générateur et un convertisseur sont reliés électriquement exclusivement par le biais d'une liaison électrique, notamment un câble, au véhicule porteur configuré sous forme de véhicule tracteur, qui est utilisé pour détecter le courant de défaut.

13. Dispositif (1) selon l'une quelconque des revendications précédentes, **caractérisé en ce que** le dispositif (1) présente plusieurs capteurs (51, 52, 53) pour la détection de défauts d'isolation, de telle sorte que la mise à la terre (15) pour l'évacuation du courant de défaut (16) dans la deuxième zone de sol (19) est utilisable en combinaison avec les plusieurs capteurs (51, 52, 53) pour une localisation de défaut.

14. Procédé d'exploitation d'un dispositif (1) selon l'une quelconque des revendications précédentes, *caractérisé en ce que* l'introduction de la haute tension est interrompue lorsqu'un courant de terre au niveau d'un appareil de mesure (21) pour mesurer un courant de défaut ou une tension de défaut dépasse une valeur limite.

Fig. 1

Fig. 2

EP 3 934 421 B1

Fig. 3

Fig. 4

Fig. 5

Fig. 6

Fig. 7

Fig. 8

Fig. 9

**Fig. 10**

**Fig. 11**

**Fig. 12**

Fig. 13

Fig. 14

Fig. 15

Fig. 16

Fig. 17

Fig. 18

80

117

119

116

118

115

## Fig. 19

125

124

12

123

120

121

122

## Fig. 20

130 131 132

138

137

136 133 134 135 139

## Fig. 21

130  141    131  132

**Fig. 22**

133  134  140

135

150

151

**Fig. 23**

Fig. 24

Fig. 25

260

261

262

271

271

Hochspannungsausgang

| 263 | 264 | 265 | 266 | 267 | 268 |

...

CPU

270

269

Elektrische
Verbindung
(Kommunikationskabel)

## Fig. 26

241

15

21

9

250

251

252

3

5

246

253

254

242

4

## Fig. 27

306   307   HV

303

301

300   302   310

309

311

## Fig. 28

Chassis

Generator

L1

L2

L3

N

$V_{mess}$

Transformator

⊕   ⊖

HV
Ausgang

Nutzstromfluss

## Fig. 29

Fig. 30

Fig. 31

POWER

Applikatoren

363

360

361 362 364

Fig. 32

Seilbefestigung

375

370

371

372

373

374

Traktorfront

Fig. 33

450

451

452

453

454

455

Fig. 34

503    504    Frame

502

500

501

Ground

Fig. 35

Fig. 36

Fig. 37

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP H05103573 A
- WO 2018095451 A1